(19) Europäisches Patentamt
European Patent Office
Office européen des brevets

(11) **EP 2 487 930 B1**

(12) **EUROPEAN PATENT SPECIFICATION**

(45) Date of publication and mention
of the grant of the patent:
**22.05.2013 Bulletin 2013/21**

(51) Int Cl.:
***H04R 3/00*** *(2006.01)* ***H03G 9/02*** *(2006.01)*

(21) Application number: **12152399.7**

(22) Date of filing: **25.01.2012**

(54) **Sound signal output apparatus and sound signal output method**

Tonsignalausgabevorrichtung und Tonsignalausgabeverfahren

Appareil de traitement de signaux sonores et procédé de traitement de signaux sonores

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.02.2011 JP 2011028830**

(43) Date of publication of application:
**15.08.2012 Bulletin 2012/33**

(73) Proprietor: **Sony Corporation
Tokyo 108-0075 (JP)**

(72) Inventors:
• **TSUCHIYA, Shinpei
Minato-ku, Tokyo 108-0075 (JP)**

• **ASADA, Kohei
Minato-ku, Tokyo 108-0075 (JP)**

(74) Representative: **Robinson, Nigel Alexander Julian
D Young & Co LLP
120 Holborn
London EC1N 2DY (GB)**

(56) References cited:
EP-A2- 1 453 349         WO-A1-2006/106480
WO-A1-2008/000304    WO-A1-2008/093954
US-A1- 2006 045 304   US-A1- 2008 025 525
US-A1- 2009 245 537

## Description

The present disclosure relates to a sound signal output apparatus and a sound signal output method, and particularly to a technique according to which an output volume of a connected speaker apparatus is appropriately accumulated and controlled in accordance with an accumulation result being performed.

The disclosures described in Japanese Unexamined Patent Application Publication Nos. 3-123199, 64-1400, and 2009-159441 relate to a technique which is not for regulating reproduction sound pressure but for detecting whether or not a headphone is fitted to an ear.

For example, music and the like have generally been enjoyed with a mobile reproduction apparatus called an audio player, a media player, or the like.

In recent years, there has been a trend to regulate supply of a loud reproduction signal from a reproduction apparatus main body to a headphone for long time mainly in Europe in relation to sound reproduction performed with such a reproduction apparatus to which a headphone or earphone is connected, in order to prevent hearing loss.

In order to prevent loud sound from being listened to for long time, a countermeasure can be considered in which an output voltage of a reproduction apparatus which is currently reproducing music is cumulatively counted and a maximum value of the output voltage is forcibly decreased when the accumulative value reaches a reference value at which there is a concern that auditory perception may adversely be affected.

However, the countermeasure may have a possibility of a disadvantageous operation so as to give unnecessary restriction of the volume if a user's actual listening state is not considered. For example, if the user does not have headphones or the like fitted to listen, the output voltage during the period is accumulated, and the output volume is shifted to a low level at certain timing.

It is desirable to appropriately perform volume control as volume regulation while performing the volume regulation in order to prevent hearing loss.

US-A-2008/0025525 discloses a method for controlling volume of an earphone. The method includes first detecting if a sensor in the earphone is triggered, and then a counter begins to count the time when the sensor is triggered. The counting value of the counter represents an operating time of the earphone. The volume of the earphone is reduced when the operating time reaches a default value. Therefore, the purpose of protecting users' hearing is achieved.

WO-A-2008/093954 discloses an audio reproduction method and apparatus, in which an audio volume is automatically controlled based on audio energy and human auditory characteristics. The audio reproduction method includes splitting a reproduction audio signal into audio signals corresponding to a plurality of frequency bands, extracting audio energy for each of the frequency bands, and comparing the audio energy for each of the frequency bands with a predetermined threshold and controlling the volume of the audio signal corresponding to each of the frequency bands.

EP-A-1453349 discloses an array microphone with several individual microphones connected with a signal processor that for each individual microphone, comprises at least one digital filter, in particular for voice recognition. The system is characterized in that at least one loudspeaker is provided, which is arranged in the acquisition area of each of the individual microphones , in that an electronic circuit is provided, which applies a signal to the loudspeaker in such a manner that it emits a predetermined periodic noise signal, and in that the signal processor evaluates the response signals coming from each of the microphones and/or from each of the digital filters as a response to the reception of the periodic noise signal.

WO-A-2008/000304 discloses an earphone system with usage detection for controlling the routing of sound signals to an earphone or to a host device. The acoustic load on the earphone is detected and determines if the earphone is in a listening position at the ear of a user or not. The routing of the sound signals is based on the listening position of the earphone. If the earphone is in a listening position, the sounds are routed to the earphone, whereas if the earphone is not in a listening position, the sounds are routed to the host device.

The invention relates to an apparatus and a method according to the independent claims.

For example, the wearing state determination unit may determine the wearing state or the non-wearing state based on a change in impedance viewed from the sound signal output processing unit both in the wearing state and in the non-wearing state.

According to at least an example of the present disclosure, output volume is accumulated by detecting whether or not the speaker apparatus connected to the sound signal output apparatus is being fitted to the user's ear. That is, the accumulative value of the output volume is not computed during a period in which the speaker apparatus is not fitted to the ear, namely the period in which there is no burden exerted on the user's auditory perception. That is, the accumulative value becomes an accumulative value only during a period in which the speaker apparatus is being fitted to the user's ear, which is an appropriate value as an accumulative value for a countermeasure against hearing loss, by detecting the wearing state or the non-wearing state by the wearing state determination unit and controlling accumulation processing in accordance with the detection.

According to at least an example of the present disclosure, it is possible to detect whether or not the speaker apparatus (headphone or earphone) is being fitted to an ear regardless of how the user of the sound signal output apparatus uses the apparatus and update the accumulative value of the output volume only when the speaker apparatus is being fitted to the ear. Thus, it is possible to appropriately control volume based on the accumulative value.

Further particular and preferred aspects of the present invention are set out in the accompanying independent and dependent claims. Features of the dependent claims may be combined with features of the independent claims as appropriate, and in combinations other than those explicitly set out in the claims.

The invention and embodiments of the invention will now be described, by way of example only, with reference to the accompanying drawings in which:

Figs. 1A to 1E are explanatory diagrams of accumulative value computation according to an example embodiment of the present disclosure;

Figs. 2A to 2D are explanatory diagrams of back content and front content of a speaker in a non-wearing state and a wearing state;

Figs. 3A and 3B are explanatory diagrams of a principle of wearing state determination according to an example embodiment;

Fig. 4 is a block diagram of a reproduction apparatus according to a first example embodiment of the present disclosure;

Figs. 5A and 5B are block diagrams of a headphone wearing state determination unit according to the first example embodiment;

Fig. 6 is a flowchart of reproduction volume accumulation processing according to an example embodiment;

Figs. 7A and 7B are flowchart of processing of controlling reproduction volume accumulative computation according to an example embodiment;

Fig. 8 is a block diagram of a modified example of a headphone wearing state determination unit according to the first example embodiment;

Fig. 9 is a block diagram of a modified example of a headphone wearing state determination unit according to the first example embodiment;

Fig. 10 is a block diagram of a reproduction apparatus according to a second example embodiment;

Fig. 11 is a block diagram of a headphone wearing state determination unit according to the second example embodiment;

Fig. 12 is a block diagram of a reproduction apparatus according to a third example embodiment;

Fig. 13 is a block diagram of a headphone wearing state determination unit according to the third example embodiment;

Fig. 14 is a block diagram of a reproduction apparatus according to a fourth example embodiment;

Fig. 15 is a block diagram of a headphone wearing state determination unit according to the fourth embodiment;

Fig. 16 is a flowchart of calibration processing; and

Figs. 17A to 17E are explanatory diagrams of display examples during calibration processing according to an example embodiment.

Hereinafter, description will be given of example embodiments of the present disclosure in the following order. In the embodiments, a reproduction apparatus called an audio player or a media player is exemplified as an example of the sound signal output apparatus of the present disclosure.

Although a "headphone apparatus" is exemplified as a speaker apparatus connected to the reproduction apparatus, the headphone apparatus includes not only a so-called "headphone" but also an "earphone" as long as it is not necessary to distinguish both.

<1. Outline of accumulative computation operation according to example embodiments>
<2. Principle of headphone wearing state determination>
<3. First example embodiment>
<4. Second example embodiment>
<5. Third example embodiment>
<6. Fourth example embodiment>
<7. Modified example>

<1. Outline of accumulative computation operation according to example embodiments>

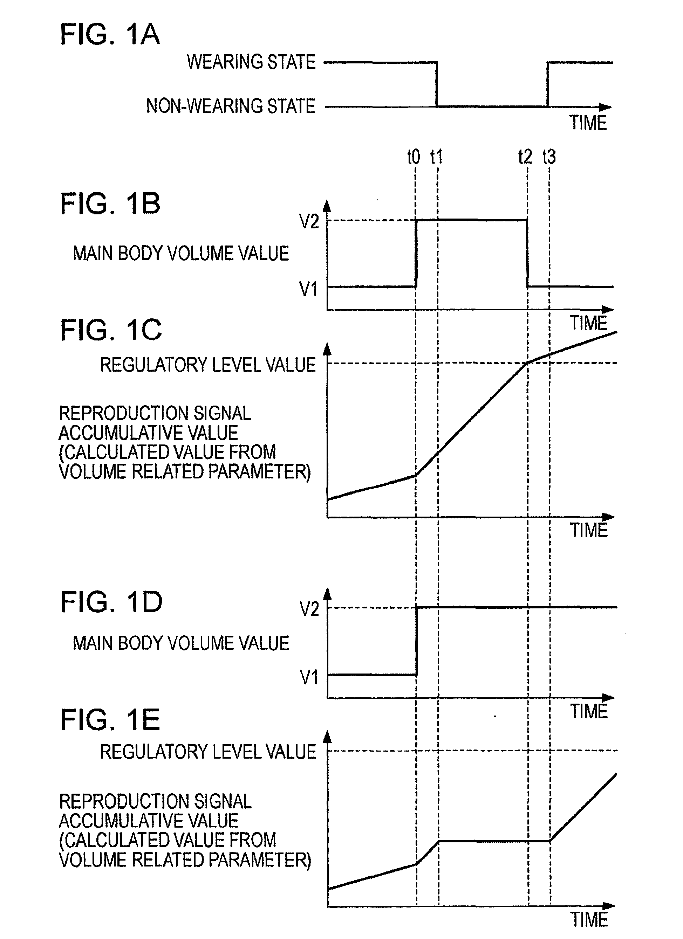

First, description will be given of output volume accumulative computation as a countermeasure against hearing loss according to embodiments with reference to Figs. 1A to 1E.

For example, in consideration of a concern in that listening to loud sound for long time causes hearing loss, the reproduction apparatus continuously and accumulatively adds output volume output to the headphone apparatus during the reproduction. Then, when the accumulative value reaches a predetermined regulatory value set in advance, the volume is forcibly turned down. For example, a gain to be given to a sound signal output to the headphone apparatus is restricted. This is an appropriate countermeasure against healing loss.

However, there is also a case in which appropriate gain restriction is not performed in practice by simply accumulating the output volume.

For example, when the headphone apparatus is removed from the ear, time accumulative counting of the output voltage is continued on the side of the reproduction apparatus if music is being reproduced. In addition, even when not the headphone apparatus but an external speaker with an amplifier or the like reproduces the music, the time accumulative counting of the output volume of the reproduction apparatus is continued in the same manner.

Moreover, there is also a case in which user is not fitting the headphone and is not listening to the music even if the music is being reproduced.

Then, even the time and the volume during the period when no burden is loaded on the user's auditory perception are added to the accumulative value, and the gain is unnecessarily controlled in some cases.

A specific example will be described with reference to Figs. 1A to 1C.

Fig. 1A shows a wearing state of a headphone apparatus into an ear of a user of the reproduction apparatus. That is, the drawing shows a state in which the user removes the headphone apparatus, which was fitted to the ear at timing t1, and fits the headphone apparatus again at timing t3.

Figs. 1B and 1C show a temporal change in the volume of the reproduction apparatus main body and a change in the accumulative value of a reproduction signal (reproduction volume) of the reproduction apparatus.

Since the time recording of the output voltage is performed based on the volume setting state of the reproduction apparatus main body as shown in the drawings, the accumulation of the time recording is gradual in the state in which the volume corresponds to v1.

Since the volume is turned up from v1 to v2 at timing t0, the time recording accumulation state is changed and becomes steep.

Since the volume is turned down from v2 to v1 at timing t2, the time recording accumulation state is changed, and the accumulation is continued at the same inclination as that in the accumulation until the timing t0. From the drawings, it is possible to understand the use state of the reproduction apparatus by the user to some extent.

In this case, however, the time recording accumulation is continued regardless of the fact that the headphone apparatus is not fitted to the ear in practice during the time from the timing t1 to the timing t3.

Since the accumulative value of the sound pressure exceeds a regulatory level at the timing t2, the upper limitation of the volume level thereafter is forcibly changed to the volume v1 by a sound pressure regulation function as shown in Fig. 1B regardless of the wearing state of the headphone.

On the other hand, Figs. 1D and 1E show a temporal change in the volume of the reproduction apparatus and a change in the reproduction volume accumulative value according to the embodiments.

The time recording accumulation is also performed at the inclination corresponding to v1. when the volume is v1 in this case as well.

Since the volume is turned up from v1 to v2 at the timing t0, the time recording accumulation state is changed and becomes steep.

The accumulation is continued at such steep inclination from the timing t0 to the timing t1.

Since the headphone apparatus is removed from the ear during the period from the timing t1 to the timing t3, however, the accumulation is not continued, and the accumulative value becomes a constant value.

When the headphone apparatus is fitted again at the timing t3, the accumulation is restarted at the timing. Since the volume is v2 at this time, the accumulation is continued at the same inclination as that in the accumulation from the timing t0 to the timing t1.

That is, the volume is not unnecessarily controlled at the timing t2, and the user can listen to the music with a desired volume (V2, for example) even after the timing t3 in this case.

As described above, the target of the computation of the output volume accumulative value as a reference of the sound pressure regulation control is limited to the headphone fitting period in order to perform the sound pressure regulation control and take measure against hearing loss, according to the embodiments. In so doing, it is possible to regulate the sound pressure in order to protect auditory perception while adapting to the use state of the reproduction apparatus such as a media player or the like by the user without excessively regulating the sound pressure.

Accordingly, a headphone wearing state determination unit which analyzes an electric output of the connected headphone apparatus and determines whether the connected headphone apparatus is in a wearing state or in a non-wearing state into the user's ear, a sound signal output processing unit which outputs a sound signal to be supplied to the headphone apparatus, and a control computation unit which computes an output volume accumulative value in accordance with a volume level and sound output time of the sound signal are provided according to the embodiments.

When the accumulative value reaches a regulatory value, the control computation unit causes the sound signal output processing unit to execute volume regulation. During the period when it is determined that the headphone apparatus is not being fitted, the computation of the accumulative value is not executed.

<2. Principle of headphone wearing state determination>

In order not to perform the accumulative computation during the period when the headphone apparatus is not being fitted to the ear of the user as described above, it is necessary to determine the wearing state or the non-wearing state of the connected headphone apparatus into the use's ear.

It is assumed that there are two kinds of sound reproduction with the use of the reproduction apparatus and the head phone apparatus according to the embodiments, one of which is reproduction in an ear while the other is reproduction outside the ear.

The reproduction in the ear represents a case in which the headphone (earphone) is wearing/inserted in the ear to listen to the sound signal. The reproduction outside the ear represents a case in which a listener listen to the sound signal via an external speaker or listen to the music while the listener removes the headphone (earphone) from the ear although the sound signal is being reproduced by the reproduction apparatus.

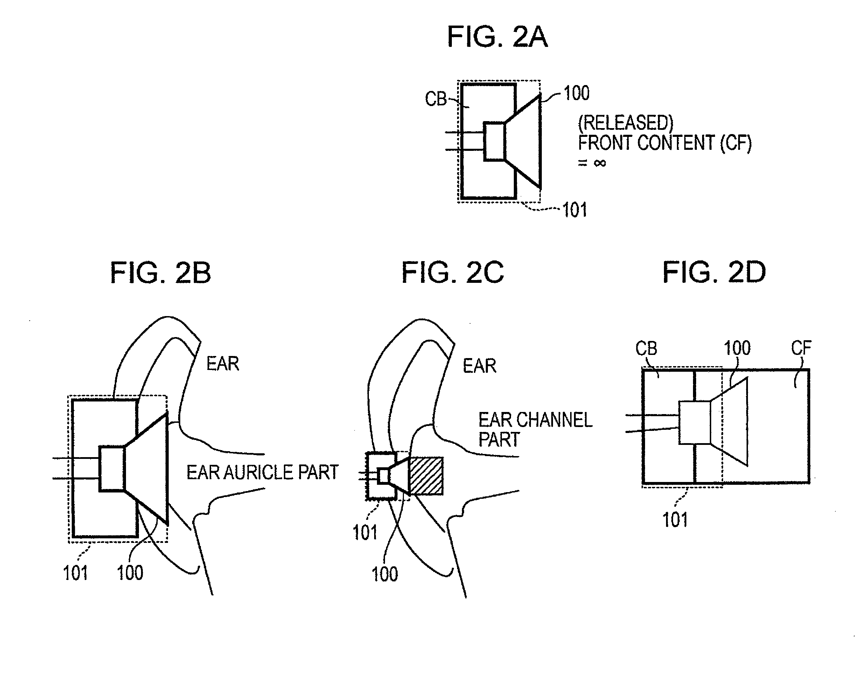

For simplification, Fig. 2A is a diagram schematically showing a state in which a sound-isolating headphone or a sound-isolating earphone is not fitted as an example. The drawing shows a speaker unit 100 and a case body 101 of the headphone (earphone).

Fig. 2B shows an image when the sound-isolating headphone is being fitted to the ear, and Fig. 2C shows a case of the sound-isolating earphone. As can be understood from Figs. 2B and 2C, the headphone apparatus maintains the sound-isolating state with the use of ear auricle spaces while the earphone maintains the sound-isolating state with the use of ear channel parts. Both can be schematically shown by the diagram of Fig. 2D.

In the case of Fig. 2A in which the headphone apparatus is in the non-wearing state with respect to the user's ear, the front surface of the speaker unit 100 is in an opened state, and therefore, the front content CF becomes equivalent to infinite. The back content CB of the speaker unit 100 corresponds to the content of the internal space of the case body 101.

On the other hand, when the sound-isolating state is secured in the wearing state shown in Figs. 2B and 2C, the front content of the headphone corresponds to the content of the ear auricle spaces while the front content of the earphone correspond to the content of the ear channel part. That is, the front content CF becomes a finite value as shown in Fig. 2D.

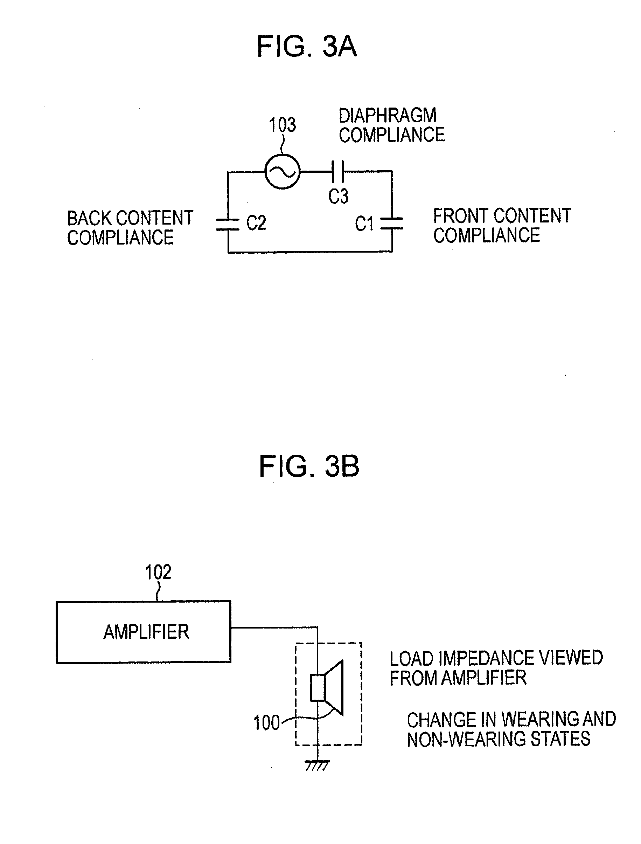

Fig. 3A shows an electrical acoustic equivalent circuit. Here, the equivalent circuit is shown by a speaker unit mechanical vibration source 103, a front content acoustic compliance C1, a back content acoustic compliance C2, and a diaphragm acoustic compliance C3.

Generally, the acoustic compliance is proportional to content. The front acoustic compliance (C1) becomes one of a large burden for the speaker unit mechanical vibration source 103 as well as the back acoustic compliance (C2) particularly in terms of the behavior in a low frequency band.

Particularly, the capacity of the front content acoustic compliance C1 in the wearing state is extremely smaller than that in the non-wearing state.

The acoustic compliance can also be understood as an "inverse of a spring constant" in general, the sound-isolating property of the front content in the wearing state is remarkable, and it is possible to say that the front content in the wearing state has a "strong spring property" in a low frequency band.

Since this "spring property" is different in the wearing state and the non-wearing state, the diaphragm itself is influenced particularly in the low frequency band.

Specifically, the diaphragm itself is pressed with an air spring by the front content when the front content in the wearing state is small, and therefore, braking is applied as compared with the non-wearing state (opened state), and the diaphragm itself is not sufficiently movable.

This will be described in view of an electric circuit outside the headphone apparatus. It is possible to understand that burden is varied as impedance in the wearing state and the non-wearing state when viewed from the amplifier 102 in Fig. 3B.

According to the embodiments, a drive output from the speaker unit 100 is different from that during reproduction outside the ear (in the non-wearing state) since acoustic burden in the ear is increased due to the fitting of the headphone or earphone during reproduction in the ear (in the wearing-state).

Thus, it is possible to determine the wearing state and the non-wearing state on the side of the reproduction apparatus by comparing the output signal influenced by the acoustic burden and the music signal to be reproduced.

That is, it is possible on the side of the reproduction apparatus to determine whether or not the speaker apparatus is being fitted to the user's ear by analyzing an electric output of the connected speaker apparatus based on the output sound signal with the use of the fact that the impedance viewed from the reproduction apparatus side is varied in the wearing state and the non-wearing state.

<3. First example embodiment>

A reproduction apparatus 1 according to a first embodiment will be described.

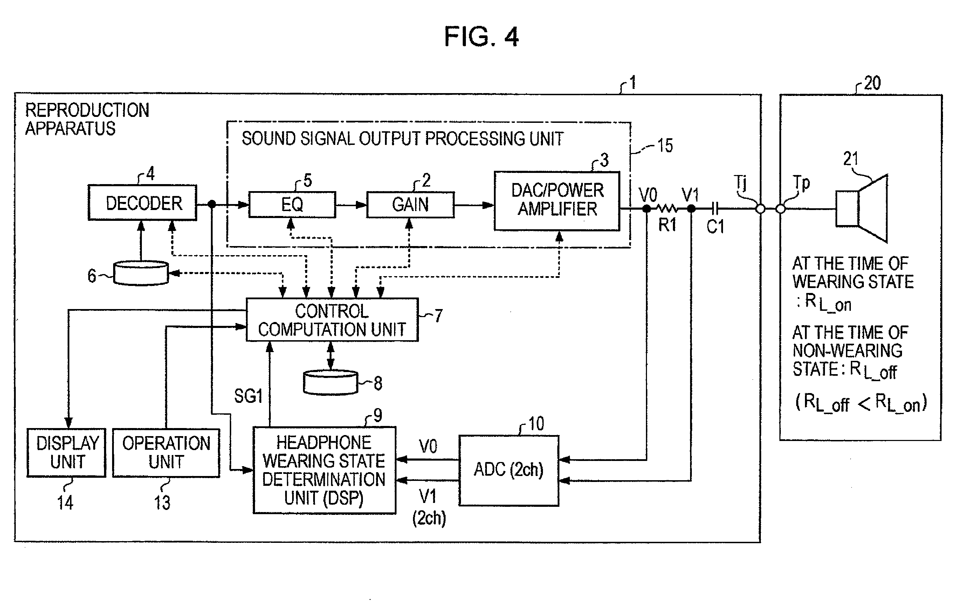

Fig. 4 is a block diagram of an internal configuration of the reproduction apparatus 1. The reproduction apparatus 1 is connected to a headphone apparatus 20. A user can listen to music or the like reproduced by the reproduction apparatus 1 by fitting the headphone apparatus 20 into the ear. The headphone apparatus 20 includes a speaker unit 21 and output sound from the speaker unit 21.

Although a single line of connection between the reproduction apparatus 1 and the headphone apparatus 20 is shown in each of Fig. 4 and Figs. 10, 12 and 14 according to second to fourth embodiments which will be described later for simplification, connection is established by two-channel sound signal paths for an L channel and an R channel in practice.

That is, the headphone apparatus 20 is provided with a speaker unit 21 for the L channel and a speaker unit for the R channel, and the user fits the parts corresponding to the speaker unit 21 into both left and right ears.

The reproduction apparatus 1 processes two-channel, sound signal for the L channel and the R channel in a sound signal output processing unit 15, which will be described later, and supplies each of the sound signals from the two lines including the L and R channels to each speaker unit 21.

The connection between the reproduction apparatus 1 and the headphone apparatus 20 is established by inserting a plug of the headphone apparatus 20 into a jack of the reproduction apparatus 1, and the jack and the plug may have three-pole terminal configurations which are usually used.

That is, a configuration including an L channel terminal, an R channel terminal, and a common ground terminal may be used.

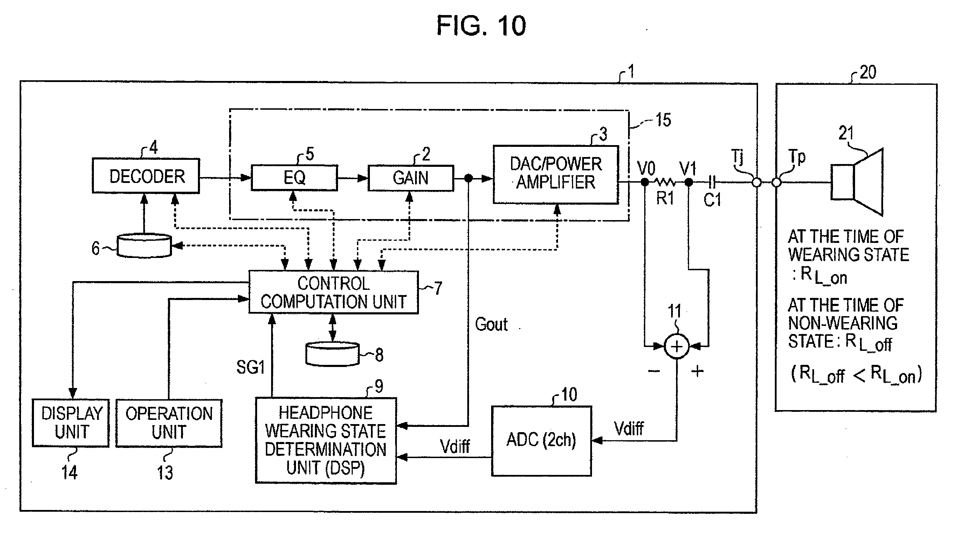

Fig. 4 (and Figs. 10, 12, and 14) shows a terminal Tj as a terminal of the jack and a terminal Tp as a terminal of the plug. Each of the terminals Tj and Tp is one terminal for the L channel or the L channel.

In the configuration described later, a resistance R1 is disposed on a sound signal transmission path for each of the L and R channels from the reproduction apparatus 1 to the headphone apparatus 20, and an A/D converter 10 and a headphone apparatus wearing state determination unit 9 are provided so as to be disposed on the sound signal transmission path for each of the L and R channel.

As shown in Fig. 4, the reproduction apparatus 1 is provided with a sound source unit 6, decoder 4, a sound signal output processing unit 15, a control computation unit 7, a storage unit 8, a headphone wearing state determination unit 9, an A/D converter 10, operation unit 13, and a display unit 14.

The sound signal output processing unit 15 is provided with an equalizer 5, a gain adjustment unit 2, and a DAC/power amplifier 3.

In addition, the resistance R1 and the capacitor C1 are connected on the sound signal transmission path on the side of the output terminal of the sound signal output processing unit 15 (DAC/power amplifier 3).

The sound source unit 6 stores sound signal data. As a specific configuration, the sound source unit 6 may be configured by a solid-state memory such as a flash memory, for example, or an HDD (Hard Disk Drive).

Alternatively, the sound source unit 6 may be configured not by a built-in recording medium but by a drive apparatus for a portable recording medium such as a memory card with a built-in solid-state memory, an optical disc such as a CD (Compact Disc), a DVD (Digital Versatile Disc), or the like, a magneto-optical disc, a hologram memory, or the like.

It is matter of course that both of the built-in memory such as a solid-state memory, an HDD, or the like and the drive apparatus for a portable recording medium may be mounted.

The sound signal data is written in and read from the sound source unit 6 based on the control by the control computation unit 7.

In addition, the sound source unit 6 stores the sound signal data such as music content and the like in a compressed coded state by a predetermined sound compression coding method.

The data such as musing content or the like read from the sound source unit 6 is supplied to the decoder 4. The decoder 4 performs necessary decoding processing in response to the control by the control computation unit 7. For example, the decoder 4 performs expansion decoding and the like on compressed data.

A decoder 4 performs necessary decoding processing and outputs an audio signal (main sound signal) as linear PCM data for each of the L and R channels, for example.

The sound signal output processing unit 15 provided with the equalizer 5, the gain adjustment unit 2, and the DAC/power amplifier 3 performs processing on the audio signal output from the decoder 4 to output the audio signal to the headphone apparatus 20 (only one line for the L or R channel is shown in the drawing as described above).

The equalizer 5 performs correction between amplitude and frequency properties, correction between phase and frequency properties, or sound correction of both.

The correction processing by the equalizer 5 is executed based on the control by the control computation unit 7. For example, the control computation unit 7 instructs a frequency property, for example.

The gain adjustment unit 2 performs amplification processing on the audio signal. A gain to be given is instructed by a control signal from the control computation unit 7.

In this example, a gain value is set to a value in accordance with sound pressure regulation as countermeasure against hearing loss in the audio gain unit 35 in some cases.

The DAC/power amplifier unit 3 performs D/A conversion processing and power amplification on the audio signal output from the gain adjustment unit 2 to obtain an output sound signal.

The processing of the DAC/power amplifier unit 3 is performed based on the control signal from the control computation unit 7.

The sound signal output from the DAC/power amplifier unit 3 is supplied to the speaker unit 21 of the headphone apparatus 20 via the resistance R1 and the capacitor C1 for DC cutting and further via the connection terminals Tj and Tp of the jack and the plug and output as sound.

The DAC/power amplifier unit 3 may be configured to perform analog power amplification processing after the D/A conversion or may be configured to perform digital amplification processing.

The resistance R1 is disposed on the sound signal delivery path to the speaker apparatus 20 at the output terminal of the sound signal output processing unit 15.

The voltage at both terminals of the resistance R1, namely sound signal voltage V0 as terminal voltage on the side of the sound signal output processing unit 15 and sound signal voltage V1 as terminal voltage on the side of the speaker apparatus 20 are input to the A/D converter 10.

The A/D converter 10 converts the sound signal voltage V0 and V1 into digital data. The sound signal voltage V0 and V1 as digital data is input to the headphone wearing state determination unit 9.

The sound signal voltage V0 and V1 becomes data numerical value corresponding to or proportional to V0 and V1 in practice when the sound signal voltage V0 and V1 is input to the A/D converter 10. However, the digitalized sound signal voltage is also expressed as V0 and V1.

The headphone wearing state determination unit 9 is formed by a computation processing apparatus such as a DSP (Digital Signal Processor), a CPU (Central Processing unit), or the like. The headphone wearing state determination unit 9 determines whether or not the headphone apparatus 20 is in a wearing state or a non-wearing state in the user's ear based on comparison processing of the input sound signal voltage V0 and V1.

Then, the headphone wearing state determination unit 9 transmits a determination signal SG to the control computation unit 7.

The operation unit 13 and the display unit 14 are provided as a user interface.

The operation unit 13 is a part on which user inputs operations by an operation key, a touch panel, or the like, for example. User operation information by the operation unit 13 is supplied to the control computation unit 7.

The display unit 14 is configured by a liquid crystal panel, an organic EL (Electroluminescence) panel, or the like and performs various kinds of display in response to the control by the control computation unit 7. For example, display in relation to a reproduction operation, display showing music content being reproduced, message display, and the like are performed.

The control computation unit 7 is formed by a microcomputer (CPU), for example, controls each part in response to a program or a user's operation by the operation unit 13, and outputs the reproduction sound signal and the like.

The control computation unit 7 causes the display unit 14 to execute necessary display in accordance with an operation status or the like.

Moreover, the control computation unit 7 executes reproduction volume accumulative computation and gain restriction processing in accordance with the computation result for the purpose of the sound regulation in this example.

The sound pressure in the ear is obtained based on a level of the sound signal, a gain value in a digital region, digital-to-analog conversion efficiency in the DAC/power amplifier unit 3, a power amplifier gain value, sensitivity information of the speaker unit 21, and the like. Accordingly, the control computation unit 7 may input the level of the sound signal from the sound source unit 6, the gain value of the gain adjustment unit 2, and the gain value of the DAC/power amplifier 3, and the like and obtain the accumulatively computed reproduction volume from temporal changes therein.

The control computation unit 7 determines whether to execute the accumulative computation based on the determination signal SG representing whether or not the headphone apparatus 20 is being fitted to the user's ear, which will be described in detail later. Specifically, the accumulative computation is executing during the period when the user is fitting the headphone apparatus 20 into the ear.

The storage unit 8 inclusively represents a ROM, a RAM, a non-volatile storage region, and the like and stores information necessary for the processing by the control computation unit 7.

For example, operation programs of the control computation unit 7, various processing coefficients, tables, and the like are stored, and the storage unit 8 is used as a work area for the computation processing. In addition, the values for the accumulation processing are maintained with the use of the non-volatile storage region or the like of the storage unit 8, for example.

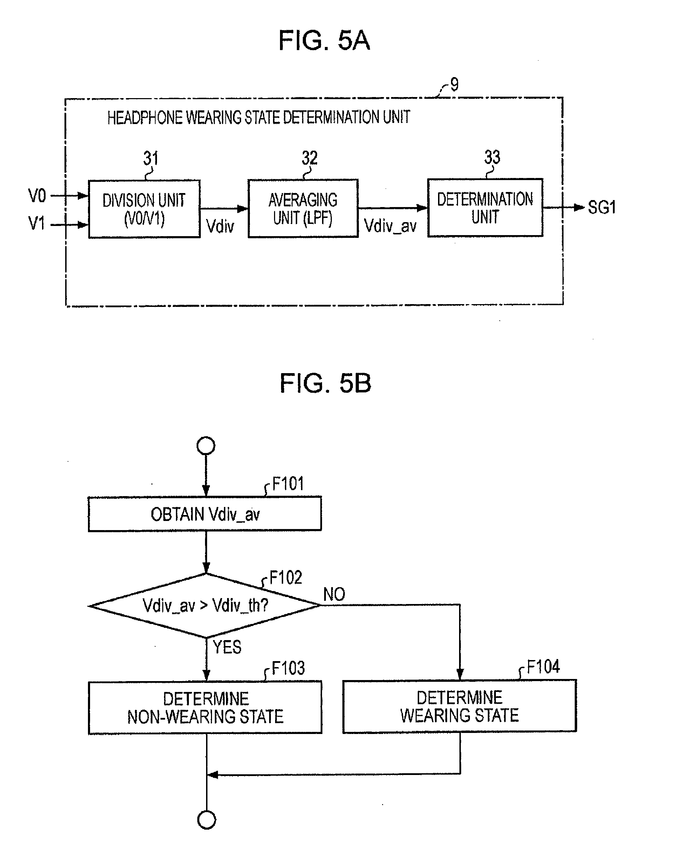

Fig. 5A shows a configuration example of the headphone wearing state determination unit 9. The headphone wearing state determination unit 9 is provided with a division unit 31, an averaging unit 32, and a determination unit 33.

As described above, the sound signal voltage V0 and V1 is input to the headphone wearing state determination unit 9.

The division unit 31 executes division of V0/V1 to obtain a divided value Vdiv.

The divided value Vdiv is averaged by a time length to some extent by the averaging unit 32. This is for obtaining an averaged value to some extent as a ratio (divided value Vdiv) of the voltage at both terminals (sound signal voltage V0 and V1) of the resistance R1 since the sound signal voltage V0 and V1 is varies on a time axis due to content of music being reproduced. The averaging unit 32 may perform low pass filter processing in practice.

The averaged divided value Vdiv_av is supplied to the determination unit 33. The determination unit 33 determines the wearing state or the non-wearing state by comparing the divided value Vdiv_av with a predetermined threshold value Vdiv_th and outputs a determination result SG1.

Next, description will be given of operations of the headphone wearing state determination unit 9. The headphone wearing state determination unit 9 analyzes an electrical output of the speaker unit 21 of the connected headphone apparatus 20 and determines whether or not the headphone apparatus 20 is in the wearing state or the non-wearing state into the user's ear.

As shown in Fig. 4, the reproduction apparatus 1 and the speaker unit 21 of the headphone apparatus 20 are connected to each other via the resistance R1. In addition, the sound signal voltage V0 immediately after the stage of the power amplifier and the sound signal voltage V1 at the part of the connection to the speaker unit 21 with an impedance value $R_L$ after passing through the resistance R1 are input to the headphone wearing state determination unit 9.

In relation to the impedance $R_L$ of the speaker unit 21, the value in the wearing state in the ear is assumed to be $R_L$ on while the value in the non-wearing state in ear is assumed to be $R_{L\_off}$.

As can be understood from the above description with reference to Fig. 2A to 3B, the relation of $R_{L\_on}>$

$R_{L\_off}$ is satisfied.

In addition, the capacitor C1 is provided for cutting direct current and equivalent to be short-circuited in terms of alternate current.

Here, one of the inputs of the A/D converter 10 corresponds to the sound signal voltage V0, and the sound signal voltage V1 can be described as V1 = V0·$R_L$/ (R1+$R_L$).

Since the impedance RL is varied to $R_{L\_off}$ in the non-wearing state and to $R_{L\_on}$ (here, $R_{L\_on}$ > $R_{L\_off}$) in the wearing state, it is possible to determine the wearing state or the non-wearing state by executing the division on the data of the sound signal voltage V0 and V1 output from the A/D converter 10 in the headphone wearing state determination unit 9 (a DSP, for example).

Here, the divided value Vdiv by the division unit 31 of the headphone wearing state determination unit 9 can be expressed by

$$Vdiv = V0/V1$$
$$= V0/\{V0 \cdot R_L/(R1+R_L)\}$$
$$= (1+R1/R_L).$$

It is possible to obtain a stable divided value Vdiv_av by further time-averaging the divided value Vdiv by the averaging unit 32.

It is possible to determine the wearing state or the non-wearing state by calculating whether the averaged divided value Vdiv_av is close to (1+R1/$R_{L\_off}$) or (1+R1/$R_{L\_on}$). That is, an intermediate value between (1+R1/$R_{L\_off}$) and (1+R1/$R_{L\_on}$) may be assumed to be the threshold value Vdiv_th to compare the averaged divided value Vdiv_av and the threshold value Vdiv_th.

Therefore, the determination unit 33 may perform the processing shown in Fig. 5B, for example.

The determination unit 33 inputs the averaged divided value Vdiv_av in Step F101 and compares the divided value Vdiv_av with the threshold value Vdiv_th in Step F102.

If Vdiv_av > Vdiv_th is satisfied, the determination unit 33 determines that the current state is the non-wearing state and outputs the determination signal SG1 in Step F103.

On the other hand, if Vdiv_av ≤ Vdiv_th is satisfied, the determination unit 33 determines that the current states is the wearing state and outputs the determination signal SG1 in Step F104.

The headphone wearing state determination unit 9 determines the wearing state or the non-wearing state as described above, for example. The control computation unit 7 performs accumulative computation processing with the use of the determination signal SG.

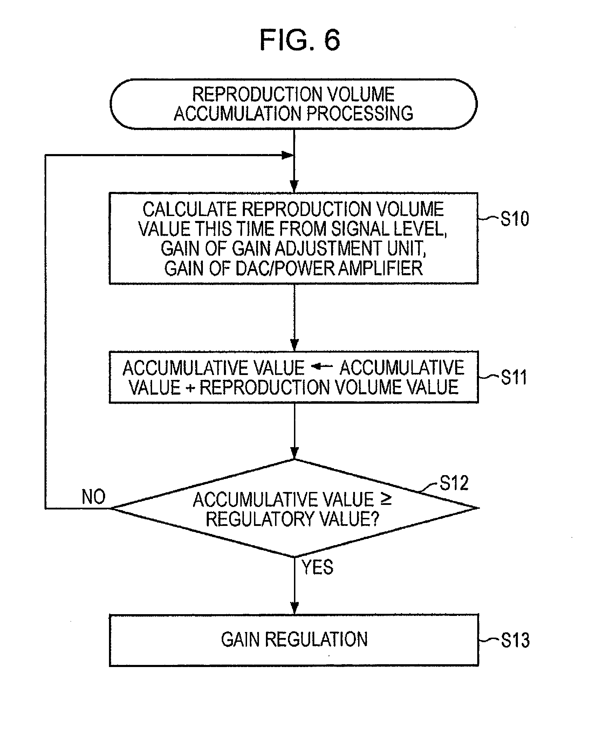

Hereinafter, description will be given of the processing by the control computation unit 7 for the sound pressure regulation with reference to Figs. 6 to 7B.

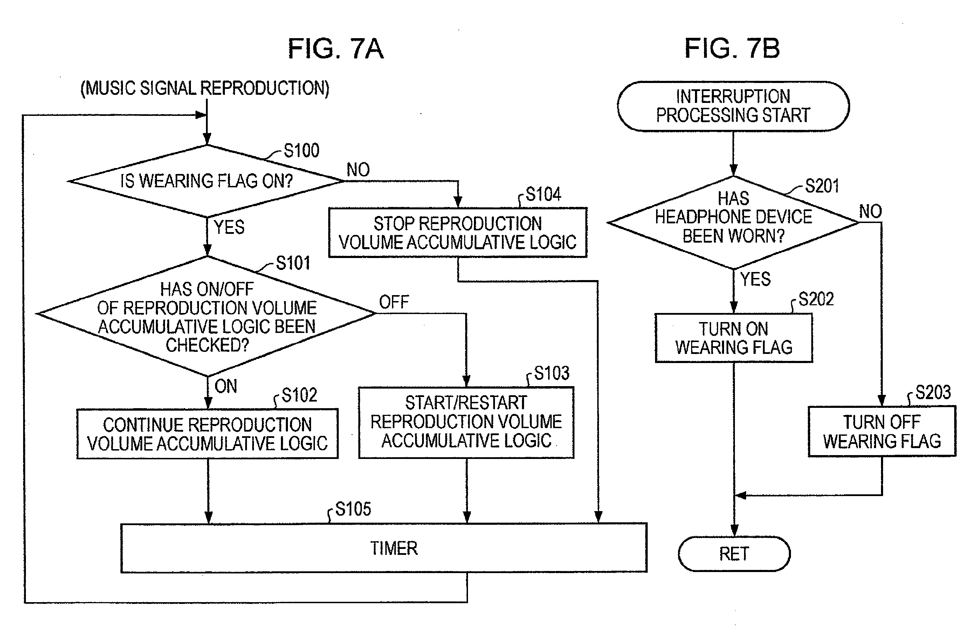

Fig. 6 shows accumulation processing and gain control processing executed by the control computation unit 7. Fig. 7A shows interruption processing executed by the control computation unit 7 every predetermined period for determining execution and stop of the accumulative computation processing in Fig. 6, and Fig. 7B shows processing of the control computation unit 7 in response to the input of the determination signal SC1 indicating the wearing state or the non-wearing state.

First, the processing shown in Fig. 6 will be described.

The control computation unit 7 continuously executes the processing shown in Fig. 6 during the reproduction.

In Step S10, the control computation unit 7 inputs a signal level of reproduced audio data, a gain of the gain adjustment unit 5, a gain of the DAC/power amplifier 3, and the like to obtain a reproduction volume value this time. For example, the control computation unit 7 obtains average values of the levels of the output audio data from the sound source unit 6, the gain values of the gain adjustment unit 5, and the gain values of the DAC/power amplifier 3 and sets a coefficient value as current volume from the average values.

That is, a coefficient corresponding to an inclination of the accumulative value shown in Fig. 1E is set. A value obtained by multiplying the coefficient by a value in target unit time is set as a reproduction volume value this time. This can be regarded as a value indicating current speaker output volume.

In Step S11, the control computation unit 7 adds the reproduction volume value this time to the current accumulative value to obtain a new accumulative value. Then, the control computation unit 7 causes the storage unit 8 to store the new accumulative value.

Until the accumulative value reaches a predetermined regulatory value in Step S12, Steps S10 and S11 are repeatedly executed in unit time. Accordingly, the accumulative value is increased with the inclination in accordance with the volume at that time as shown in Fig. 1E.

If the accumulative value reaches the regulatory value at certain timing, the control computation unit 7 moves on to Step S13 to causes the gain adjustment unit 5 to execute gain regulation.

For example, a maximum gain is regulated to a gain corresponding to the volume V1 shown in Fig. 1B. In so doing, the output sound regulation as countermeasure against hearing loss is executed.

Although Fig. 6 does not show the processing after performing the gain regulation, a configuration can be considered in which the gain regulation is released after elapse of a predetermined period.

In addition, it can be considered that the accumulative value itself is also reset after elapse of a predetermined period.

Although the control computation unit 7 constantly performs the above accumulative value computation in Fig. 6 during reproduction, the accumulative value computation processing in Steps S10 and S11 itself is stopped in some cases.

This will be described with reference to Figs. 7A and 7B.

Fig. 7B shows processing executed in the control computation unit 7 every time the determination signal SG1 from the headphone wearing state determination unit 9 is input.

In Step S201, the control computation unit 7 checks the determination signal SG1 from the headphone wearing state determination unit 9.

If the determination result shows the wearing state, the control computation unit 7 turns on a fitting state flag in Step S202.

On the other hand, the determination result shows the non-wearing state, the control computation unit 7 turns off the fitting state flag in Step S203.

Fig. 7A shows the interruption processing executed by the control computation unit 7 every predetermined period in accordance with timer processing in Step S105.

In Step S100, the control computation unit 7 determines whether or not the headphone apparatus 20 is being fitted to the ear based on the state of the aforementioned fitting flag. If the fitting state flag is turned on, it is determined that the headphone apparatus 20 is being currently fitted in the ear, and the processing proceeds to Step S101.

In Step S101, the control computation unit 7 checks whether or not the reproduction volume accumulating operation, namely the processing in Steps S10 and S11 in Fig. 6 is being currently executed.

If the reproduction volume accumulating operation is being performed, the control computation unit 7 moves on to Step S102 to continue the reproduction volume accumulation processing.

If the reproduction volume accumulating operation is being stopped, the control computation unit 7 moves on to Step S103 to star or restart the reproduction volume accumulation processing.

When the wearing flag has confirmed to be in the off state in Step S100, the control computation unit 7 determines that the headphone apparatus 20 is not being currently fitted to the ear and moves on to Step S104. Then, the reproduction volume accumulating operation is stopped.

After the completion of the processing in Steps S102, S103, and S104, the processing operation moves on to Step S105. In Step S105, predetermined standby time is set, and the above operation is repeated after the standby time. In addition, the standby time may be set to zero.

The control computation unit 7 performs the accumulative value computation as described above with reference to Fig. 1E by performing the above processing shown in Figs. 6 to 7B.

That is, it is possible to detect whether or not the headphone apparatus 20 is being fitted to the ear regardless of how the user uses the reproduction apparatus 1 and accumulate the reproduction signal from the reproduction apparatus 1 only when the headphone apparatus 20 is being fitted to the ear. Therefore, the gain restriction based on the accumulative value becomes appropriate sound pressure restriction processing.

For example, it is possible to realize a function of lowering a maximum value of output voltage when the accumulative value reaches a reference value at which there is a concern that auditory perception is adversely affected in unit time such as one week or the like, in relation to the reproduction by the reproduction apparatus 1 which is currently reproducing music.

In such a case, the accumulative computation is not performed during the period when the user is not fitting the headphone apparatus 20 into the ear, namely the period in which there is no burden on the user's ear, and therefore unnecessary sound pressure regulation is not performed, and it is possible to realize appropriate sound pressure regulation and avoid giving disadvantages due to unnecessary regulation to the user.

According to this embodiment, the connection between the reproduction apparatus 1 and the headphone apparatus 20 may be established with a jack and a plug with ordinary configurations including three-pole terminals. That is, it is not necessary to provide a special terminal for determining whether or not the headphone apparatus 20 is being fitted.

For this reason, the reproduction apparatus 1 appropriately determines the wearing state or the non-wearing state regardless of what kind of headphone apparatus 20 is connected thereto, appropriate accumulative computation is performed, and the sound pressure regulation processing can be realized as a result.

That is, the reproduction apparatus 1 can be an apparatus which includes compatibility mainly with a headphone or an earphone having three-pole terminals and is provided with a hearing loss preventing function which can adapts to the use state by the user.

According to this embodiment, the headphone wearing state determination unit 9 performs the division processing of the sound signal voltage V0 and V1 as the comparison processing of the sound signal voltage V0 and V1 and determines the wearing state or the non-wearing state based on the division result. The sound signal voltage V0 and V1 is varied in a time-series manner due to the content of the reproduced sound, and therefore, it is possible to correctly obtain a voltage ratio between both terminals of the resistance R1 and thereby to correctly determine the wearing state by performing the determination with the use of the divided value.

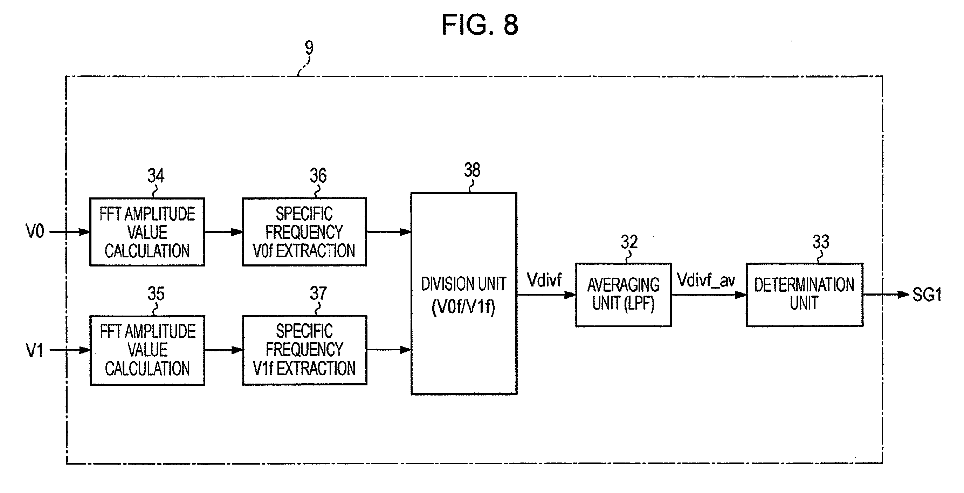

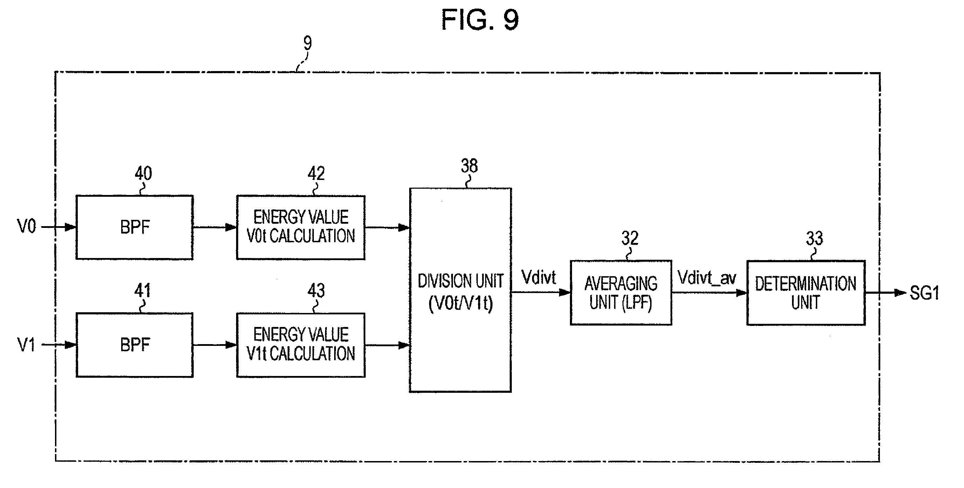

Here, description will be given of other configuration examples of the headphone wearing state determination unit 9 as modified examples of the first embodiment with reference to Figs. 8 and 9.

Generally, it has been known that the impedance RL of the speaker unit 21 has an imaginary component formed by capacitive and inductive components. As a result, the impedance RL has a frequency property, and it is possible to consider a method with a configuration shown in Fig. 8, in which an amplitude value of a specific frequency is divided with the use of FFT and a method with a configuration shown in Fig. 9, in which a specific frequency band is restricted with a band pus filter (BPF) for time axis processing to perform the division, in views of the above circumstance for the headphone wearing state determination unit 9.

In Fig. 8, the headphone wearing state determination unit 9 is provided with FFT amplitude value calculation units 34 and 35, specific frequency extracting units 36 and 37, the division unit 38, the averaging unit 32, and the determination unit 33.

As described above, the sound signal voltage V0 and V1 which has been converted into digital data by the A/D converter 10 is input to the headphone wearing state determination unit 9.

In relation to the sound signal voltage V0 and V1, amplitude values of each frequency band are calculated by the FFT amplitude value calculation units 34 and 35, respectively.

Moreover, amplitude values V0f and V1f at a specific frequency are extracted by the specific frequency extracting units 36 and 37.

The division unit 31 performs division of V0f/V1f to obtain a divided value Vdivf. That is, a divided value of the sound signal voltage V0 and V1 in the extracted specific frequency band is obtained.

The divided value Vdivf is averaged in a certain time length by the averaging unit 32 to obtain an averaged divided value Vdivf_av. The averaged divided value Vdivf_av is supplied to the determination unit 33. The determination unit 33 determines the wearing state or the non-wearing state by comparing the divided value Vdivf_av averaged in the processing of Fig. 5B with a predetermined threshold value Vdiv_th and outputs a determination result SG1. In this case, the threshold value Vdiv_th may be a threshold value by which an amplitude ratio in the specific frequency bands extracted by the specific frequency extracting units 36 and 37 is closer to $(1+R1/R_{L\_off})$ or $(1+R1/R_{L\_on})$.

In the configuration example shown in Fig. 9, the headphone wearing state determination unit 9 is provided with BPFs 40 and 41, energy value calculation units 42 and 43, the division unit 38, the averaging unit 32, and the determination unit 33.

The sound signal voltage V0 and V1 which has been converted into digital data by the A/D converter 10 is input to the headphone wearing state determination unit 9. In relation to the sound signal voltage V0 and V1, specific frequency bands are extracted by the BPFs 40 and 41, respectively.

Moreover, the energy value calculation units 42 and 43 extract energy values V0t and V1t in the extracted specific frequency bands.

The division unit 31 performs division of V0t/V1t to obtain a divided value Vdivt. That is, a divided value of the energy of the sound signal voltage V0 and V1 in the extracted specific frequency bands is obtained.

The divided value Vdivt is averaged in a certain time length by the averaging unit 32 to obtain an averaged divided value vdivt_av.

The determination unit 33 determines the wearing state or the non-wearing state by comparing the divided value Vdivt_av averaged in the processing shown in Fig. 5B with a predetermined threshold value and outputs a determination result SG1. In this case, the threshold value Vdiv_th may be a threshold value by which an energy ratio (amplitude ratio) between the specific frequency extracting units extracted by the BPFs 40 and 41 is closer to $(1+R1/R_{L\_off})$ or $(1+R1/R_{L\_on})$

As described above, it is also preferable for correct wearing state determination to perform division processing of the sound signal voltage V0 and V1 in specific frequency bands by the headphone wearing state determination unit 9 as shown in Figs. 8 and 9. Since, the change in the impedance viewed from the sound signal output processing unit 15 in the wearing state and the non-wearing state is particularly significant in a specific frequency band in some cases, it is possible to facilitate the determination with the use of such a frequency band component.

<4. Second example embodiment>

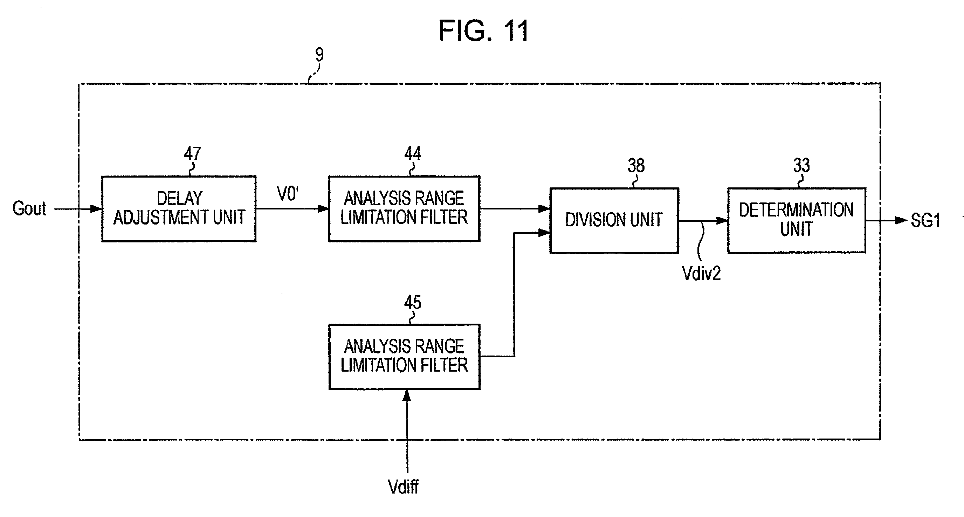

Next, description will be given of the reproduction apparatus 1 according to a second embodiment with reference to Figs. 10 and 11. The same reference numerals are given to the same components as those in Figs. 4 to 5B, and the description thereof will not be repeated.

Fig. 10 is different from Fig. 4 in that a subtractor 11 is provided and a signal Gout output from the gain adjustment unit 2 is supplied to the headphone wearing state determination unit 9.

The subtractor 11 inputs sound signal voltage V0 and V1 as voltage at both terminals of the resistance R1 and outputs a value of V1- V0 as a difference value Vdiff.

The difference value Vdiff is converted into digital data by the A/D converter 10 and input to the headphone wearing state determination unit 9.

In addition, the signal Gout from the gain adjustment unit 2, namely a sound signal as digital data in a step before power amplification processing is input to the headphone wearing state determination unit 9.

Fig. 11 shows a configuration example of the headphone wearing state determination unit 9.

The headphone wearing state determination unit 9 is provided with a delay adjustment unit 47, analysis range limitation filters 44 and 45, the division unit 38, and the determination unit 33.

To the signal Gout output from the gain adjustment unit 2, predetermined delay time is given by the delay adjustment unit 47. The delay adjustment unit 47 gives delay time corresponding to processing time of the DAC/power amplifier unit 3 to the signal Gout in the course of the sound signal processing. Here, the delayed signal is expressed as V0'

From the signal V0' delayed by predetermined time, a component in a specific frequency band is extracted with the analysis range limitation filter 44.

From the difference value Vdiff from the A/D converter 10, a component in the specific frequency band is extracted with the analysis range limitation filter 45.

The division unit 38 performs division of V0'/Vdiff (each of which is the component in the extracted specific frequency band).

Then, the divided value Vdiv2 is supplied to the determination unit 33, and the determination unit 33 performs substantially the same processing as that shown in Fig. 5B on the divided value Vdiv2 to output a determination signal SG1.

Operations in the second embodiment are as follows.

While the divided value of the sound signal voltage V0 and V1 are used as a base in the first embodiment, determination is performed with the use of the subtracted value (difference value) of the sound signal voltage V0 and V1 according to the second embodiment.

When a difference value obtained by the subtractor 11 is expressed as Vdiff, and a value which has been converted into digital data by the A/D converter 10 is also expressed as Vdiff,

$$\text{Vdiff} = \text{V0}-\text{V1}$$
$$= \text{V0}-\{\text{V0}\cdot\text{R}_L/(\text{R1}+\text{R}_L)\}$$
$$= \text{V0}\cdot\{\text{R1}/(\text{R1}+\text{R}_L)\}$$

is obtained.

Here, the signal Gout is used as a value corresponding to the voltage V0 immediately after the output from the stage of the power amplification in the headphone wearing state determination unit 9. In such a case, division is performed while the component of the signal Gout at the specific frequency is used as the signal V0' ($\approx$ V0) as described above. The divided value Vdiv2 is expressed as:

$$\text{Vdiv2} = \text{Vdiff}/\text{V0}'$$
$$= \text{V0}\cdot\{\text{R1}/(\text{R1}+\text{R}_L)\}/\text{V0}'$$
$$\approx \text{R1}/(\text{R1}+\text{R}_L)$$

Therefore, the divided value Vdiv2 becomes a value which is different in accordance with the change in the impedance of the speaker unit 21 due to the wearing state or the non-wearing state, and it is possible to determine the wearing state by comparing the divided value Vdiv2 with the threshold value Vdiv_th as shown in Fig. 5B.

According to the second embodiment, the headphone wearing state determination unit 9 generates the signal V0' corresponding to the terminal voltage (sound signal voltage V0) of the resistance R1 on the side of the sound signal output processing unit 15 based on the sound signal voltage (signal Gout) in the course of the processing in the sound signal output processing unit 15. Then, the determination between the wearing state and the non-wearing state is performed with the divided value Vdiv2 of the difference value Vdiff of the sound signal voltage V0 and V1 and the signal V0'. That is, the wearing state determination is performed by the comparison processing between the difference value Vdiff and the signal V0'.

In this case, accumulative computation is appropriately performed by the control computation unit 7 based on the appropriate wearing state determination in the same manner as in the first embodiment, and the sound pressure regulating operation is executed in accordance with the use state of the user.

In order to approximate the signal V0' to the sound signal voltage V0, a configuration can be considered in which analysis adjustment equalizer processing in consideration of the frequency property in the DAC/power amplifier unit 3 is performed on the output signal of the delay adjustment unit 47, for example.

Although it is not necessary to provide the analysis range limitation filters 44 and 45, the analysis range limitation filters 44 and 45 can reduce errors and enhance determination accuracy by extracting a component in a specific frequency band and performing processing. In order to further reduce errors, a configuration is also applicable in which averaging processing is performed on the divided value Vdiv2 and the determination processing in the determination unit 33 is performed with the use of the averaged divided value Vdiv2 in the same manner as in the first embodiment.

In addition, the subtraction processing of the sound signal voltage V0 and V1 for obtaining the difference value Vdiff may be performed in the headphone wearing state determination unit 9 (DSP). However, it is possible to reduce the number of input channels of the A/D converter 10 and reduce the computation resources of the headphone wearing state determination unit 9 (DSP) by performing the subtraction processing on the analog circuit with the use of the subtractor 11 as shown in Fig. 10.

<5. Third example embodiment>

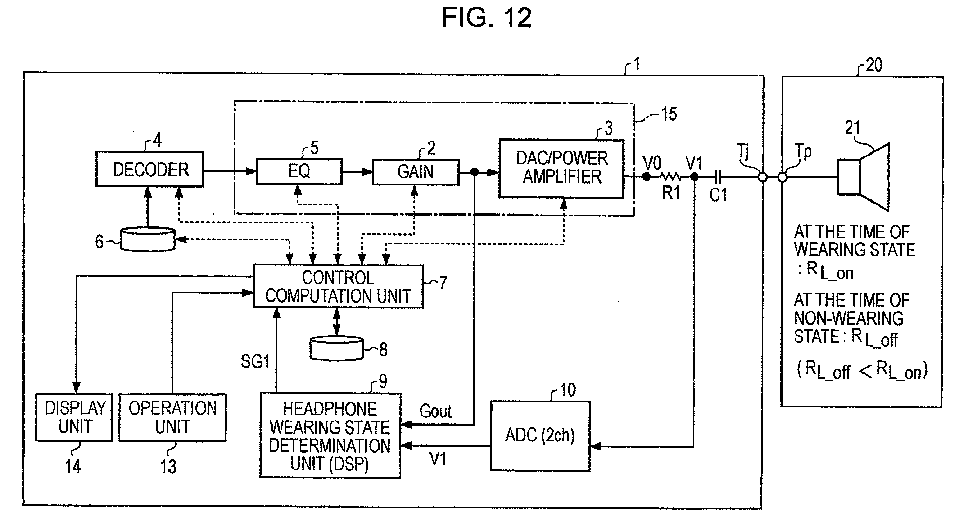

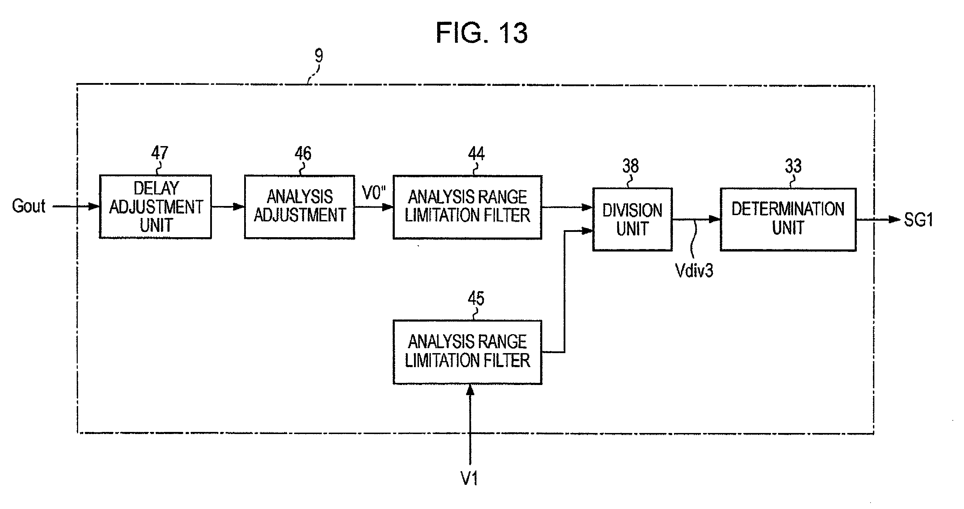

Next, description will be given of the reproduction apparatus 1 according to a third embodiment with reference to Figs. 12 and 13. In Fig. 12, the same reference numerals are given to the same components as those in Fig. 4, and the description thereof will not be repeated.

Fig. 12 is different from Fig. 4 in that only the sound signal voltage V1 is input to the headphone wearing state determination unit 9 via the A/D converter 10. That is, the sound signal voltage V0 is not used, and the sound signal voltage V1 is converted into digital data by the A/D converter 10 and input to the headphone wearing state determination unit 9.

In addition, the signal Gout output from the gain adjustment unit 2 is supplied to the headphone wearing state determination unit 9.

According to the third embodiment, the signal V0' corresponding to the sound signal voltage V0 is generated in the headphone wearing state determination unit 9 (DSP).

Fig. 13 shows a configuration example of the headphone wearing state determination unit 9.

The headphone wearing state determination unit 9 is provided with the delay adjustment unit 47, an analysis adjustment equalizer 46, the analysis range limitation filters 44 and 45, the division unit 38, and the determination unit 33.

To the signal Gout output from the gain adjustment unit 2, predetermined delay time is given by the delay adjustment unit 47. The delay adjustment unit 47 gives delay time corresponding to the processing time of the DAC/power amplifier unit 3 to the signal Gout in the course of the sound signal processing. Here, the delayed signal is expressed as V0'.

In relation to the signal V0', only a component in a certain frequency band is extracted with the analysis range limitation filter 44.

In relation to the sound signal voltage V1 from the A/D converter 10, only a component in the specific frequency band is extracted with the analysis range limitation filter 45.

The division unit 38 performs division of V0"/V1 (each of which is a component in the extracted specific frequency band).

Then, the divided value Vdiv3 is supplied to the determination unit 33, and the determination unit 33 performs substantially the same processing as that in Fig. 5B on the divided value Vdiv3 to output the determination signal SG1.

According to the third embodiment, the value of the sound signal voltage V0 is assumed to be sufficiently predictable when viewed from the headphone wearing state determination unit 9, and the delay adjustment unit 47 and the analysis adjustment equalizer 46 generates the signal V0" corresponding to the sound signal voltage V0.

For this reason, the analysis adjustment equalizer 46 performs the analysis adjustment equalizer processing on the signal Gout in consideration of the frequency property in the DAC/power amplifier unit 3.

As a result, it is possible to consider that the divided value Vdiv 3 is substantially the same value as the divided value Vdiv in the first embodiment. Therefore, it is possible to determine the wearing state by comparing the divided value Vdiv3 with the threshold value Vdiv_th by the determination unit 33.

According to the third embodiment, the headphone wearing state determination unit 9 generates the signal V0" corresponding to the terminal voltage (sound signal voltage V0) of the resistance R1 on the side of the sound signal output processing unit 15 based on the sound signal voltage (signal Gout) in the course of the processing by the sound signal output processing unit 15 as described above. Then, the wearing state or the non-wearing state is determined by the comparison processing between the generated signal V0" and the sound signal voltage V1.

Particularly, to the sound signal voltage (signal Gout) in the source of the processing by the sound signal output processing unit 15, signal compensation corresponding to the processing by the sound signal output processing unit 15 (processing by the DAC/power amplifier unit 3) after the aforementioned processing is added by the analysis adjustment equalizer 46 to generate the signal V0" corresponding to the sound signal voltage V0.

In this case, the control computation unit 7 appropriately performs accumulative computation and executes the sound pressure regulating operation in accordance with the use state of the user based on the appropriate wearing state determination in the same manner as in the first embodiment.

In addition, it is possible to reduce the number of input channels of the A/D converter 10 in the same manner as in the second embodiment.

Although it is not necessary to provide the analysis range limitation filters 44 and 45, the analysis range limitation filters 44 and 45 can reduce errors and enhance determination accuracy by extracting a component in a specific frequency band and performing processing.

In order to further reduce errors, a configuration is also applicable in which averaging processing is performed on the divided value Vdiv3 and the determination processing in the determination unit 33 is performed with the use of the averaged divided value Vdiv3 in the same manner as in the first embodiment.

Although the output Gout of the gain adjustment unit 2 is input to the headphone wearing state determination unit 9 in this example, the output signal of the decoder 4 may be input to the headphone fitted state determination unit 9. In such a case, the delay adjustment unit 47 and the analysis adjustment equalizer 46 give delay time and signal compensation corresponding to the processing by the equalizer 46, the gain adjustment unit 2, and the DAC/power amplifier unit 3 to generate the signal V0" corresponding to the sound signal voltage V0.

In addition, the output of the equalizer 46 may be input to the headphone fitted state determination unit 9. In such a case, the delay adjustment unit 47 and the analysis adjustment equalizer 46 give delay signal and signal compensation corresponding to the processing by the gain adjustment unit 2 and the DAC/power amplifier unit 3 to generate the signal V0" corresponding to the sound signal voltage V0.

<6. Fourth example embodiment>

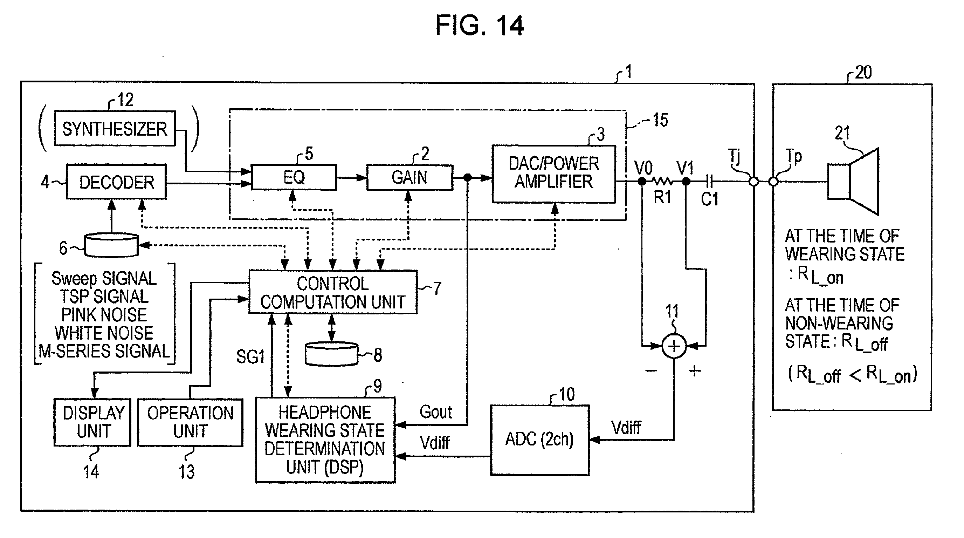

Next, description will be given of a fourth embodiment with reference to Figs. 14 to 17E. The fourth embodiment explains how calibration is performed for the wearing state determination in accordance with individual users.

That is, calibration is performed in consideration of how the headphone apparatus is fitted in an ear of each individual in practice (a habit when the individual wears the headphone) and how the shape of the ear is (content).

According to the embodiments described above, it is assumed that "average threshold values" for an average wearing method in relation to how the headphone apparatus is fitted and for a typical ear shape are used. However, parameters for each threshold value in the earphone or the headphone are greatly varied particularly in the low frequency band due to how the earphone or the headphone is fitted (there is a gap although the above embodiments are considered on the assumption of the sound-isolating state, for example). That is, the "habits when the individuals wear the headphone or the earphone" greatly effects the parameters.

Accordingly, it is possible to more correctly reflect threshold values including an acoustic circuit in the ear and the ear channel by performing frequency response measurement in advance before the reproduction and reflecting the measurement result data to the system and thereby to form a correct sound pressure control system.

Thus, the control computation unit 7 causes the sound signal output processing unit 15 to output a measurement signal in each of the wearing state and the non-wearing state and causes the headphone wearing state determination unit 9 to execute frequency response measurement relating to the sound signal voltage V0 and V1. For example, the headphone wearing state determination unit 9 is made to execute the frequency response measurement in relation to the sound signal voltage V0 and V1 itself, the difference value therebetween, the divided value therebetween, and the like. Then, the headphone wearing state determination unit 9 is made to execute adjustment setting in accordance with the result of the frequency response measurement.

Fig. 14 shows a configuration example of the reproduction apparatus 1 according to the fourth embodiment. The configuration example is an example in which the configuration according to the second embodiment shown in Fig. 10 is used as a base. The same reference numerals are given to the same components as those in Fig. 10, and the description thereof will be omitted.

In the case of Fig. 14, an ordinary operation at the time of the reproduction, namely a reproduction operation of music or the like, accumulative computation at that time, wearing state determination, and accumulative computation in accordance with the wearing state determination are executed or suspended in the same manner as in the aforementioned embodiments. However, calibration is performed prior to the reproduction, and therefore, the sound source unit 6 stores data as a measurement signal.

The measurement signal includes a sweep signal (a signal which sweeps and outputs frequencies from a low frequency band to a high frequency band), a TSP (Time Stretched Pulse) signal, pink noise, white noise, an M-sequential signal and the like, for example.

The control computation unit 7 instructs the sound source unit 6 to output the measurement signal at the time of executing calibration. The measurement signal is supplied to the speaker unit 21 of the connected headphone apparatus 20 via the decoder 4, the sound signal output processing unit 15 and output as sound.

Alternatively, the sound source unit 6 does not store such measurement signal data, and a synthesizer 12 is provided and made to generate a sweep signal, a TSP signal, pink noise, white noise, and an M-sequential signal.

The control computation unit 7 instructs the synthesizer 12 to output the measurement signal at the time of executing calibration. The measurement signal is supplied to the speaker unit 21 of the connected headphone apparatus 20 via the sound signal output processing unit 15 and output as sound.

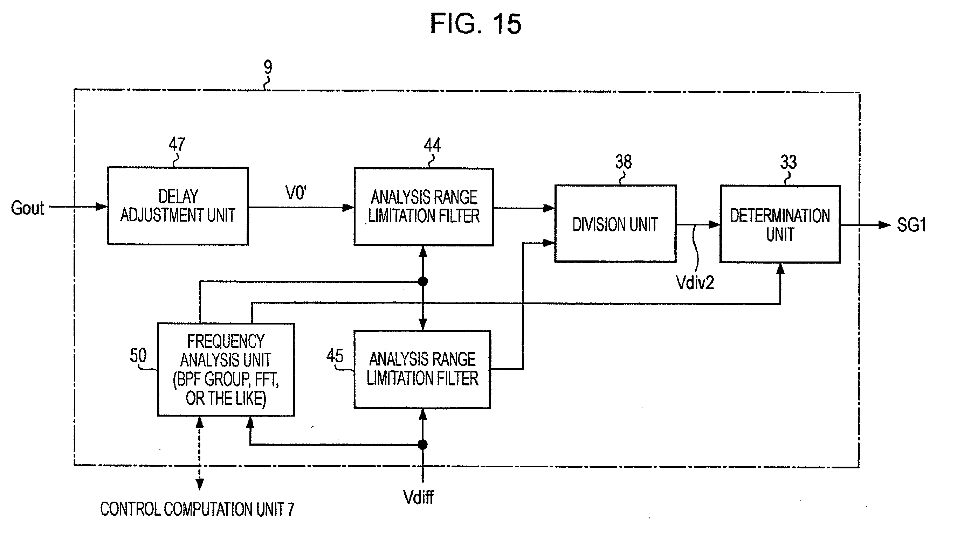

The headphone wearing state determination unit 9 has a configuration shown in Fig. 15. In the configuration shown in Fig. 15, a frequency analysis unit 50 is further provided in the configuration shown in Fig. 11. The frequency analysis unit 50 is a band pass filter group or an FFT unit, for example, to measure frequency response. For example, the frequency analysis unit 50 performs amplitude value analysis or energy analysis for each frequency band.

In such a case, frequency response is measured both in the non-wearing state and the wearing state as calibration.

Since necessary frequency response of "each individual" is an individual difference value Vdiff by the subtractor 11, the value may be measured for each individual. Therefore, the difference value Vdiff is supplied to the frequency analysis unit 50.

The frequency analysis unit 50 adjusts and sets extracted frequencies by the analysis range limitation filters 44 and 45, for example, as a calibration result.

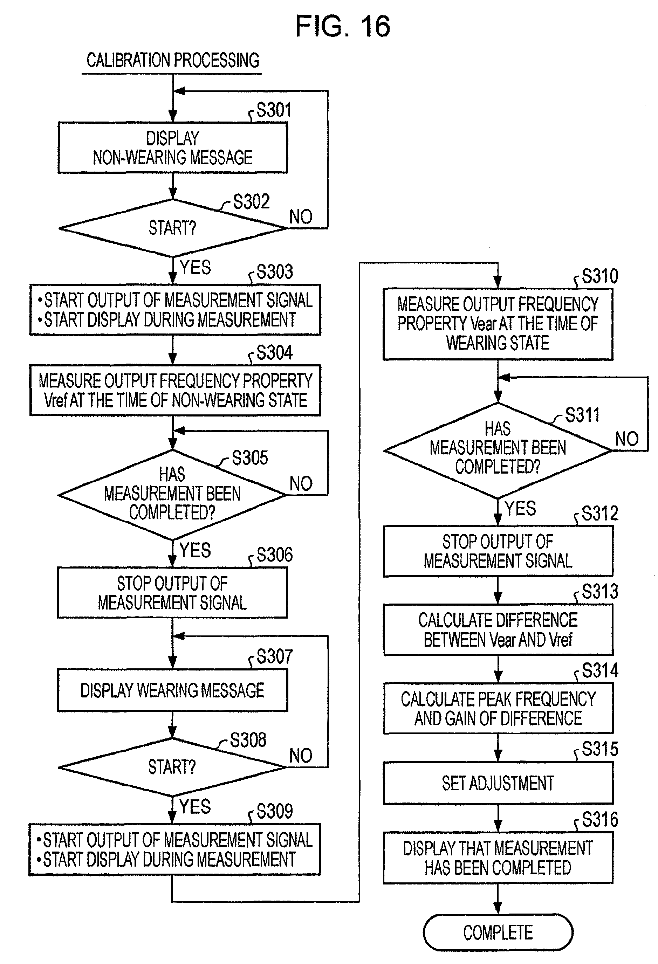

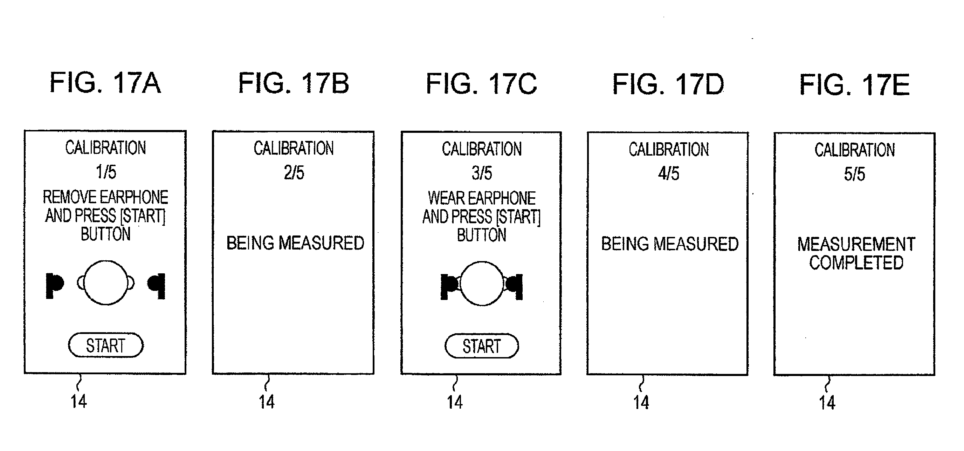

Fig. 16 shows calibration control processing executed by the control computation unit 7. The control computation unit 7 cooperates with the frequency analysis unit 50 to execute the processing in Fig. 16. Figs. 17A to 17E show display content examples by the display unit 14 at the time of executing calibration.

The control computation unit 7 executes the calibration control processing at predetermining timing such as timing of initial setting when the user uses the reproduction apparatus for the first time, timing when the user operates to input an instruction, timing when the power is turned on, and the like, for example.

When the calibration is started, the control computation unit 7 firstly controls the display in Step S301 in Fig. 16 and causes the display unit 14 to execute message display which requests the user not to wear the headphone apparatus. As shown in Fig. 17A, for example, the display unit 14 is made to display a text such as "remove earphone and press [start] button" or the like or an image representing the same message for the user.

Then, the control computation unit 7 waits for the operation of the start button by the user in Step S302.

The user presses the start button (an icon for operating a touch panel on the display, for example) in the operation unit 13 in a state in which the headphone apparatus 20 is removed from the ear in response to the display shown in Fig. 17A.

In response to this operation, the control computation unit 7 moves on to Step S303 to start the output of the measurement signal. That is, the control computation unit 7 instructs the sound source unit 6 or the synthesizer 12 to output the measurement signal. In so doing, the output of the measurement signal such as a sweep signal or the like is started. In addition, the control computation unit 7 instructs the frequency properties and the gains in the equalizer 5, the gain adjustment unit 2, the DAC/amplifier unit 3, and the like of the sound signal output processing unit 15 to be in the standard states.

Moreover, the control computation unit 7 causes the display unit 14 to execute the display which represents that the measurement is being performed as shown in Fig. 17B for the user.

If the output of the measurement signal is started as described above, the control computation unit 7 instructs the frequency analysis unit 50 in the headphone wearing state determination unit 9 to execute the analysis processing in Step S304.

The frequency analysis unit 50 executes the frequency response measurement on the input difference value Vdiff. That is, the frequency analysis unit 50 performs the frequency response measurement in the non-wearing state to obtain an output frequency property Vref in the non-wearing state.

The control computation unit 7 waits for the completion of the measurement by the frequency analysis unit 50 in Step S305. When the measurement is completed, the control computation unit 7 moves on to Step S306 to cause the sound source unit 6 or the synthesizer 12 to complete the output of the measurement signal.

Next, the control computation unit 7 causes the display unit 14 to execute message display which requests the user to wear the headphone apparatus 20 in Step S307. As shown in Fig. 17C, for example, the display unit 14 displays a text such as "wear earphone and press [start] button" or the like or an image representing the message for the user.

Then, the control computation unit 7 waits for the operation of the start button by the user in Step S308.

The user presses the start button in the operation unit 13 in the state in which the headphone apparatus 20 is fitted to the ears in response to the display shown in Fig. 17C.

In response to the operation, the control computation unit 7 moves on to Step S309 to restart the output of the measurement signal. That is, the control computation unit 7 instructs the sound source unit 6 or the synthesizer 12 to output the measurement signal. In so doing, the output of the measurement signal such as a sweep signal or the like is started. The control computation unit 7 instructs the frequency properties and the gains in the equalizer 5, the gain adjustment unit 2, the DAC/power amplifier unit 3, and the like of the sound signal output processing unit 15 to be in the standard states in this case as well.

Then, the control computation unit 7 causes the display unit 14 to execute the display which represents that the measurement is being performed as shown in Fig. 17D for the user.

If the output of the measurement signal is started as described above, the control computation unit 7 instructs the frequency analysis unit 50 in the headphone wearing state determination unit 9 to execute the analysis processing in Step S310.

The frequency analysis unit 50 executes the frequency response measurement on the input difference value Vdiff. That is, the frequency response measurement in the wearing state is performed this time to obtain an output frequency property Vear in the wearing state.

The control computation unit 7 waits for the completion of the measurement by the frequency analysis unit 50 in Step S311. When the measurement is completed, the control computation unit 7 moves on to Step S312 to causes the sound source unit 6 or the synthesizer 12 to complete the output of the measurement signal.

Since the frequency response measurement in both the non-wearing state and the wearing state was performed in the above processing, the control computation unit 7 (or the frequency analysis unit 50) performs computation based on the measurement result.

In Step S313, a difference between the output frequency property Vear in the wearing state and the output frequency property Vref in the non-wearing state is firstly obtained.

In Step S314, the control computation unit 7 (or the frequency analysis unit 50) calculates a peak frequency and a gain of the difference value.

In Step S315, the control computation unit 7 (or the frequency analysis unit 50) performs adjustment setting. For example, a frequency bands corresponding to the obtained peak frequency is set to a specific frequency band which is a pass band of the analysis range limitation filters 44 and 45. In addition, the band with less difference between the wearing state and the non-wearing state is cut. Moreover, the threshold value Vdiv_th in the determination unit 33 is adjusted based on the gain of the difference value.

The control computation unit 7 causes the display unit 14 to execute the display which represents the completion of the measurement as shown in Fig. 17E, shows that the calibration has been completed to the user, and completes a series of calibration control in Step S316.

By executing calibration as described above, it is possible to determine the wearing state in accordance with how the user wears the headphone apparatus (a habit when the user wears the headphone apparatus) and how the shape of the ear is (content) during the reproduction after the calibration and thereby to enhance the precision in the wearing state determination.

That is, the band extracted by the analysis range limitation filters 44 and 45 becomes a range in accordance with the user individual in the case of the configurations shown in Figs. 14 and 15, and as a result, an obvious difference appears in the divided values Vdiv2 in the wearing state and the non-wearing state, which makes it possible to reduce mistakes in the determination by the determination unit 33.

Although the configurations in Figs. 10 and 11 according to the second embodiment are used as base in the examples shown in Figs. 10 and 11, it can also be considered that calibration is executed in the configuration according to the first or third embodiment, of course.

In the case of the first embodiment, the sound source unit 6 in Fig. 4 is made to store the measurement signal data such as a sweep signal or the like and output the measurement signal, or the synthesizer 12 is provided. In addition, the frequency analysis unit 50 which performs the frequency response measurement on the divided value Vdiv or the sound signal voltage V0 and V1 may be provided in the headphone fitted state determination unit 9 shown in Figs. 5A, 5B, 8, and 9. Then, the control computation unit 7 executes the processing shown in Fig. 16.

When the headphone fitted state determination unit 9 has a configuration shown in Figs. 5A and 5B, it can be considered that the threshold value Vdiv_th in the determination unit 33 is adjusted as a result of the calibration result.

When the headphone fitted state determination unit 9 has a configuration shown in Fig. 8, it can be considered that the threshold value Vdiv_th in the determination unit 33 and the frequency extracted by the specific frequency extracting units 36 and 37 are adjusted as a result of the calibration result.

Moreover, when the headphone fitted state determination unit 9 has a configuration shown in Fig. 9, it can be considered that the threshold value Vdiv_th in the determination unit 33 and the pass frequency of the band pass filters 40 and 41 are adjusted as a result of the calibration result.

In the case of the third embodiment, the sound source unit 6 in Fig. 12 is made to store the measurement signal data such as a sweep signal or the like to output the measurement signal, or the synthesizer 12 is provided. In addition, the frequency analysis unit 50 which performs the frequency response measurement on the sound signal voltage V1 or the divided value Vdiv3 may be provided in the headphone fitted state determination unit 9 shown in Fig. 13. Then, the control computation unit 7 performs the processing shown in Fig. 16.

It can be considered that the threshold value Vdiv_th in the determination unit 33, the parameter values of the frequency property of the analysis adjustment equalizer 46, and the extracted frequency bands by the analysis range limitation filters 44 and 45 are adjusted as a result of the calibration result.

It is possible to reduce opportunities in that the user suffers disadvantages due to erroneous determination and execute reproduction sound pressure control in an actually correct situation by adjusting the equalizer property, the extracted bands, the threshold values, and the like for the signals used in the determination of the wearing state or the non-wearing state with a value calculated by the calibration for each individual as described above.

<7. Modified example>

Although description was give of the first to fourth embodiment, various modified examples can further be considered as embodiment of the present disclosure.

Although the description was made of each embodiment in which one of the L and R channels is shown as the sound signal transmission path for the speaker unit 21 of the headphone apparatus 20, a two-channel configuration including the L and R channels is used in more cases in practice as described above.

In such a case, the resistance R1 is disposed on the sound signal transmission path of each channel, and determination processing by the headphone fitted state determination unit 9 is performed corresponding to each channel.

In such a case, there is a case in which the current state is determined to be the wearing state on the side of one channel (one speaker unit 21) while the current state is determined to be the non-wearing state on the side of the other channel.

In addition, it is needless to say that the present disclosure can be applied not only to a two-channel stereo reproduction system for L and R channels but also to a monaural reproduction system.

Moreover, it is possible to apply the present disclosure to a reproduction system with a noise canceling function. In relation to the noise canceling function, a microphone is provided on the side of the headphone apparatus 20, for example. A noise canceling function is a system in which a reverse phase signal of noise coming from the outside, which has been obtained by the microphone, is added to the sound signal to offset the noise in the output space of the speaker unit 21.

In relation to the accumulative computation by the control computation unit 7, the accumulative computation may be continued when the current state is determined to be the wearing state for at least one channel. This is because it is possible to consider a situation in which the user listen to the sound only with one ear and the burden of the sound pressure is exerted on the ear in this case as well. That is, it is appropriate that the accumulative computation is suspended when the current state is determined to the non-wearing state for both channels.

However, a processing example can also be considered in which the accumulative computation is suspended when the current state is determined to the non-wearing state for at least one channel.

Alternatively, another configuration can also be considered in which the wearing state determination is performed only on one channel side among the two channels.

Although the gain restriction is performed by the gain adjustment unit 2 when the sound volume regulation is determined to be performed as a result of the accumulative computation in the above embodiments, it is matter of course that the gain restriction may be performed in the stage of the power amplification of the DAC/power amplifier unit 3.

That is, the sound regulation may be performed at any timing in the course of the processing by the sound signal output processing unit 15.

In addition, the resistance R1 may also function as a resistance for regulating the sound pressure. As the sound pressure regulation as a countermeasure against the hearing loss, it is possible to consider a configuration in which the maximum sound pressure is controlled to be within a predetermined level as well as the configuration in which the sound volume restriction is performed as in the embodiments.

In such a case, a resistance component element is disposed on the sound signal path to the speaker unit 21 to reduce an appearance of speaker sensitivity. When such a configuration is employed, the resistance component element can be used as the resistance R1 shown in each embodiment.

Although the reproduction apparatus 1 is exemplified as an embodiment of the sound signal output apparatus of the present disclosure, the sound signal output apparatus of the present disclosure can be realized as a receiver apparatus, a radio tuner, or the like which does not incorporates a sound source unit and receives and outputs a sound signal transmitted from an outside sound source, for example.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

It should be understood by those skilled in the art that various modifications, combinations, sub-combinations and alterations may occur depending on design requirements and other factors insofar as they are within the scope of the appended claims or the equivalents thereof.

## Claims

1. A sound signal output apparatus (1) comprising:

    a wearing state determination unit (9) which analyzes an electric
    output of a connectable speaker (21) apparatus and determines whether the speaker apparatus is in a wearing state or in a non-wearing state in a user's ear;
    a sound signal output processing unit (15) which outputs a sound signal to be supplied to the speaker apparatus; and
    a control computation unit (7) which computes an accumulative value of output volume in accordance with a volume level and sound output time of the sound signal, causes the sound signal output processing unit to execute volume regulation when the accumulative value reaches a regulatory value, and does not compute the accumulative value during a period in which it is determined by the wearing state determination unit that a current state is the non-wearing state;
    a resistance component element (R1) disposed on a sound signal transmission path from the sound signal output processing unit to the connected speaker apparatus;
    wherein the wearing state determination unit determines the wearing state or the non-wearing state based on a change in impedance viewed from the sound signal output processing unit both in the wearing state and in the non-wearing state;
    wherein the wearing state determination unit determines to wearing state or the non-wearing state based on comparison processing between a first sound signal voltage as a terminal voltage of the resistance component element on the side of the sound signal output processing unit and a second sound signal voltage as a terminal voltage of the resistance component element on the side of the speaker apparatus; and
    wherein the control computation unit causes the sound signal output processing unit to output a measurement signal in each of the wearing state and the non-wearing state and causes the wearing state determination unit to execute frequency response measurement relating to the first sound signal voltage and the second sound signal voltage and execute adjustment setting that calibrates the wearing state determination unit in accordance with a result of the frequency response measurement.

2. The sound signal output apparatus according to Claim 1, wherein the wearing state determination unit performs division processing on the first sound signal voltage and the second sound signal voltage as the comparison processing to determine the wearing state or the non-wearing state from a division result.

3. The sound signal output apparatus according to Claim 2, wherein the wearing state determination unit performs the division processing on a specific frequency component in each of the first sound signal voltage and the second sound signal voltage.

4. The sound signal output apparatus according to Claim 1, wherein the wearing state determination unit generates the first sound signal voltage corresponding to the terminal voltage of the resistance component element on the side of the sound signal output processing unit based on sound signal voltage in the course of processing in the sound signal output processing unit and determines the wearing state or the non-wearing state by comparison processing of the generated first sound signal voltage with a difference value between the first sound signal voltage and the second sound signal voltage.

5. The sound signal output apparatus according to Claim 1, wherein the wearing state determination unit generates the first sound signal voltage corresponding to the terminal voltage of the resistance component element on the side of the sound signal output processing unit based on sound signal voltage in the course of processing in the sound signal output processing unit and determines the wearing state or the non-wearing state by comparison processing of the generated first sound signal voltage with the second sound signal voltage.

6. A sound signal output method comprising the steps of:

   analyzing with a wearing state determination unit an electric output of a connectable speaker apparatus and determining whether the speaker apparatus is in a wearing state or in a non-wearing state in a user's ear;
   computing an accumulative value of output volume in accordance with a volume level and sound output time of a sound signal to be supplied from a sound signal output processing unit to the speaker apparatus only during a period in which it is determined that a current state is the wearing state,
executing volume regulation on the sound signal to be supplied to the speaker apparatus when the accumulative value reaches a regulatory value,
disposing a resistance component element (R1) on a sound signal transmission path from the sound output processing unit to the connected speaker apparatus;
wherein the step of analyzing determines the wearing state or the non-wearing state based on a change in impedance viewed from the sound signal output processing unit both in the wearing state and in the non-wearing state;
the step of analyzing determines the wearing state or the non-wearing state based on comparison processing between a first sound signal voltage as a terminal voltage of the resistance component element on the side of the sound signal output processing unit and a second sound signal voltage as a terminal voltage of the resistance component element on the side of the speaker apparatus and said method further comprising the steps of:

   outputting from the sound signal output processing unit a measurement signal in each of the wearing state and the non-wearing state; and
   executing frequency response measurement relating to the first sound signal voltage and the second sound signal voltage and execute adjustment setting that calibrates the wearing state determination unit in accordance with a result of the frequency response measurement.

**Patentansprüche**

1. Tonsignal-Ausgabevorrichtung (1), umfassend:

   eine Tragezustands-Bestimmungseinheit (9), die eine elektrische Ausgabe einer verbindbaren Lautsprechervorrichtung (21) analysiert und bestimmt, ob sich die Lautsprechervorrichtung in einem Tragezustand oder in einem Nicht-Tragezustand in dem Ohr eines Benutzers befindet;
   eine Tonsignal-Ausgabeverarbeitungseinheit (15), die ein der Lautsprechervorrichtung zuzuführendes Tonsignal ausgibt; und
   eine Steuerberechnungseinheit (7), die einen akkumulativen Wert der Ausgabelautstärke gemäß einem Lautstärkepegel und einer Tonausgabezeit des Tonsignals berechnet, bewirkt, dass die Tonsignal-Ausgabeverarbeitungseinheit Lautstärkeregelung ausführt, wenn der akkumulative Wert einen Vorschriftswert erreicht, und den akkumulativen Wert während eines Zeitraums, in dem durch die Tragezustands-Bestimmungseinheit bestimmt wird, dass ein aktueller Zustand der Nicht-Tragezustand ist, nicht berechnet;

ein auf einem Tonsignal-Übertragungspfad von der Tonsignal-Ausgabeverarbeitungseinheit zu der verbundenen Lautsprechervorrichtung angeordnetes Widerstandskomponentenelement (R1);

wobei die Tragezustands-Bestimmungseinheit den Tragezustand oder Nicht-Tragezustand auf der Basis einer Impedanzänderung bestimmt, die von der Tonsignal-Ausgabeverarbeitungseinheit sowohl im Tragezustand als auch im Nicht-Tragezustand gesehen wird;

wobei die Tragezustands-Bestimmungseinheit den Tragezustand oder Nicht-Tragezustand auf der Basis von Vergleichsverarbeitung zwischen einer ersten Tonsignalspannung als Anschlussspannung des Widerstandskomponentenelements auf der Seite der Tonsignal-Ausgabeverarbeitungseinheit und einer zweiten Tonsignalspannung als Anschlussspannung des Widerstandskomponentenelements auf der Seite der Lautsprechervorrichtung bestimmt; und

wobei die Steuerberechnungseinheit bewirkt, dass die Tonsignal-Ausgabeverarbeitungseinheit im Tragezustand und im Nicht-Tragezustand jeweils ein Messsignal ausgibt, und bewirkt, dass die Tragezustands-Bestimmungseinheit Frequenzgangmessung in Bezug auf die erste Tonsignalspannung und die zweite Tonsignalspannung ausführt und Justierungseinstellung ausführt, die die Tragezustands-Bestimmungseinheit gemäß einem Ergebnis der Frequenzgangmessung kalibriert.

2. Tonsignal-Ausgabevorrichtung nach Anspruch 1, wobei die Tragezustands-Bestimmungseinheit die Teilungsverarbeitung an der ersten Tonsignalspannung und der zweiten Tonsignalspannung als die Vergleichsverarbeitung ausführt, um den Tragezustand oder den Nicht-Tragezustand aus einem Teilungsergebnis zu bestimmen.

3. Tonsignal-Ausgabevorrichtung nach Anspruch 2, wobei die Tragezustands-Bestimmungseinheit die Teilungsverarbeitung an einer spezifischen Frequenzkomponente jeweils in der ersten Tonsignalspannung und der zweiten Tonsignalspannung ausführt.

4. Tonsignal-Ausgabevorrichtung nach Anspruch 1, wobei die Tragezustands-Bestimmungseinheit die erste Tonsignalspannung entsprechend der Anschlussspannung des Widerstandskomponentenelements auf der Seite der Tonsignal-Ausgabeverarbeitungseinheit auf der Basis der Tonsignalspannung im Verlauf des Verarbeitens in der Tonsignal-Ausgabeverarbeitungseinheit erzeugt und den Tragezustand oder Nicht-Tragezustand durch Vergleichsverarbeitung der erzeugten ersten Tonsignalspannung mit einem Differenzwert zwischen der ersten Tonsignalspannung und der zweiten Tonsignalspannung bestimmt.

5. Tonsignal-Ausgabevorrichtung nach Anspruch 1, wobei die Tragezustands-Bestimmungseinheit die erste Tonsignalspannung entsprechend der Anschlussspannung des Widerstandskomponentenelements auf der Seite der Tonsignal-Ausgabeverarbeitungseinheit auf der Basis der Tonsignalspannung im Verlauf der Verarbeitung in der Tonsignal-Ausgabeverarbeitungseinheit erzeugt und den Tragezustand oder Nicht-Tragezustand durch Vergleichsverarbeitung der erzeugten ersten Tonsignalspannung mit der zweiten Tonsignalspannung bestimmt.

6. Tonsignal-Ausgabeverfahren mit den folgenden Schritten:

Analysieren einer elektrischen Ausgabe einer verbindbaren Lautsprechervorrichtung mit einer Tragezustands-Bestimmungseinheit und Bestimmen, ob sich die Lautsprechervorrichtung in einem Tragezustand oder in einem Nicht-Tragezustand in dem Ohr eines Benutzers befindet;

Berechnen eines akkumulativen Werts der Ausgabelautstärke gemäß einem Lautstärkepegel und einer Tonausgabezeit eines von einer Tonsignal-Ausgabeverarbeitungseinheit der Lautsprechervorrichtung zuzuführenden Tonsignals nur während eines Zeitraums, in dem bestimmt wird, dass ein aktueller Zustand der Tragezustand ist,

Ausführen von Lautstärkeregelung an dem der Lautsprechervorrichtung zuzuführenden Tonsignal, wenn der akkumulative Wert einen Vorschriftswert erreicht,

Anordnen eines Widerstandskomponentenelements (R1) auf einem Tonsignal-Übertragungspfad von der Tonausgabeverarbeitungseinheit zu der verbundenen Lautsprechervorrichtung;

wobei der Schritt des Analysierens den Tragezustand oder den Nicht-Tragezustand auf der Basis einer Impedanzänderung bestimmt, die von der Tonsignal-Ausgabeverarbeitungseinheit sowohl im Tragezustand als auch im Nicht-Tragezustand gesehen wird, bestimmt;

wobei der Schritt des Analysierens den Tragezustand oder den Nicht-Tragezustand auf der Basis von Vergleichsverarbeitung zwischen einer ersten Tonsignalspannung als Anschlussspannung des Widerstandskomponentenelements auf der Seite der Tonsignal-Ausgabeverarbeitungseinheit und einer zweiten Tonsignalspannung als Anschlussspannung des Widerstandskomponentenelements auf der Seite der Lautsprechervorrichtung bestimmt und das Verfahren ferner die folgenden Schritte umfasst:

Ausgeben eines Messsignals von der Tonsignal-Ausgabeverarbeitungseinheit jeweils im Tragezustand und im Nicht-Tragezustand; und
Ausführen einer Frequenzgangmessung in Bezug auf die erste Tonsignalspannung und die zweite Tonsignalspannung und Ausführen einer Justierungseinstellung, die die Tragezustands-Bestimmungseinheit kalibriert, gemäß einem Ergebnis der Frequenzgangmessung.

## Revendications

1. Appareil émetteur de signal sonore (1) comprenant :

- une unité de détermination d'état de port (9) qui analyse une sortie électrique d'un appareil à haut-parleur connectable (21) et détermine si l'appareil à haut-parleur est à l'état porté ou à l'état non porté dans l'oreille d'un utilisateur ;
- une unité de traitement de sortie de signal sonore (15) qui émet un signal sonore à envoyer vers l'appareil à haut-parleur ; et
- une unité de calcul de commande (7) qui calcule une valeur accumulative d'un volume de sortie en fonction d'un niveau de volume et d'un temps d'émission sonore du signal sonore, qui ordonne à l'unité de traitement de sortie de signal sonore d'exécuter un ajustement de volume lorsque la valeur accumulative atteint une valeur de régulation, et ne calcule pas la valeur accumulative pendant une période durant laquelle l'unité de détermination d'état de port a déterminé que l'état courant est l'état non porté ;
- un élément à composant de type résistance (R1) disposé sur un trajet de transmission de signal sonore depuis l'unité de traitement de sortie de signal sonore vers l'appareil à haut-parleur connecté ;
dans lequel l'unité de détermination d'état de port détermine l'état porté ou l'état non porté en fonction d'un changement de l'impédance vu depuis l'unité de traitement de sortie de signal sonore à l'état porté et à l'état non porté ;
dans lequel l'unité de détermination d'état de port détermine l'état porté ou l'état non porté en fonction d'un traitement de comparaison entre une première tension de signal sonore représentant une tension de borne de l'élément à composant de type résistance du côté de l'unité de traitement de sortie de signal sonore, et une seconde tension de signal sonore représentant une tension de borne de l'élément à composant de type résistance du côté de l'appareil à haut-parleur ; et
dans lequel l'unité de calcul de commande ordonne à l'unité de traitement de sortie de signal sonore d'émettre un signal de mesure dans chacun des états porté et non porté, et ordonne à l'unité de détermination d'état de port d'exécuter une mesure de réponse de fréquence concernant la première tension de signal sonore et la seconde tension de signal sonore et d'exécuter un réglage d'ajustement qui calibre l'unité de détermination d'état de port en fonction du résultat de la mesure de réponse de fréquence.

2. Appareil émetteur de signal sonore selon la revendication 1, dans lequel l'unité de détermination d'état de port effectue un traitement par division sur la première tension de signal sonore et la seconde tension de signal sonore en tant que traitement de comparaison afin de déterminer l'état porté ou l'état non porté à partir d'un résultat de division.

3. Appareil émetteur de signal sonore selon la revendication 2, dans lequel l'unité de détermination d'état de port effectue le traitement par division sur une composante de fréquence spécifique dans chacune de la première tension de signal sonore et de la seconde tension de signal sonore.

4. Appareil émetteur de signal sonore selon la revendication 1, dans lequel l'unité de détermination d'état de port génère la première tension de signal sonore correspondant à la tension de borne de l'élément à composant de type résistance du côté de l'unité de traitement de sortie de signal sonore en fonction de la tension du signal sonore au cours du traitement dans l'unité de traitement de sortie de signal sonore, et détermine l'état porté ou l'état non porté par traitement de comparaison entre la première tension de signal sonore générée et une valeur de différence entre la première tension de signal sonore et la seconde tension de signal sonore.

5. Appareil émetteur de signal sonore selon la revendication 1, dans lequel l'unité de détermination d'état de port génère la première tension de signal sonore correspondant à la tension de borne de l'élément à composant de type résistance du côté de l'unité de traitement de sortie de signal sonore en fonction de la tension du signal sonore au cours du traitement dans l'unité de traitement de sortie de signal sonore, et détermine l'état porté ou l'état non porté par traitement de comparaison entre la première tension de signal sonore générée et la seconde tension de signal sonore.

6.  Procédé d'émission de signal sonore comprenant les étapes consistant à :

    - analyser, à l'aide d'une unité de détermination d'état de port, une sortie électrique d'un appareil à haut-parleur connectable, et déterminer si l'appareil à haut-parleur est à l'état porté ou à l'état non porté dans l'oreille d'un utilisateur ;
    - calculer une valeur accumulative d'un volume de sortie en fonction d'un niveau de volume et d'un temps d'émission sonore d'un signal sonore à envoyer d'une unité de traitement de sortie de signal sonore vers l'appareil à haut-parleur uniquement pendant une période durant laquelle il est établi que l'état courant est l'état porté ;
    - exécuter un ajustement de volume du signal sonore à envoyer vers l'appareil à haut-parleur lorsque la valeur accumulative atteint une valeur de régulation ;
    - disposer un élément à composant de type résistance (R1) sur un trajet de transmission de signal sonore depuis l'unité de traitement de sortie sonore vers l'appareil à haut-parleur connecté ;
    dans lequel l'étape d'analyse consiste à déterminer l'état porté ou l'état non porté en fonction d'un changement de l'impédance vu depuis l'unité de traitement de sortie de signal sonore à l'état porté et à l'état non porté ;
    l'étape d'analyse consiste à déterminer l'état porté ou l'état non porté en fonction d'un traitement de comparaison entre une première tension de signal sonore représentant une tension de borne de l'élément à composant de type résistance du côté de l'unité de traitement de sortie de signal sonore, et une seconde tension de signal sonore représentant une tension de borne de l'élément à composant de type résistance du côté de l'appareil à haut-parleur ; et lequel procédé comprend en outre les étapes consistant à :
    - émettre depuis l'unité de traitement de sortie de signal sonore un signal de mesure dans chacun des états porté et non porté ; et
    - exécuter une mesure de réponse de fréquence concernant la première tension de signal sonore et la seconde tension de signal sonore, et exécuter un réglage d'ajustement qui calibre l'unité de détermination d'état de port en fonction du résultat de la mesure de réponse de fréquence.

## FIG. 1A

WEARING STATE

NON-WEARING STATE

TIME

t0 t1    t2 t3

## FIG. 1B

MAIN BODY VOLUME VALUE

V2

V1

TIME

## FIG. 1C

REGULATORY LEVEL VALUE

REPRODUCTION SIGNAL
ACCUMULATIVE VALUE
(CALCULATED VALUE FROM
VOLUME RELATED PARAMETER)

TIME

## FIG. 1D

V2

V1

MAIN BODY VOLUME VALUE

TIME

## FIG. 1E

REGULATORY LEVEL VALUE

REPRODUCTION SIGNAL
ACCUMULATIVE VALUE
(CALCULATED VALUE FROM
VOLUME RELATED PARAMETER)

TIME

# FIG. 2A

CB — 100

(RELEASED)
FRONT CONTENT (CF)
= ∞

101

# FIG. 2B

EAR

EAR AURICLE PART

101    100

# FIG. 2C

EAR

EAR CHANNEL
PART

101

100

# FIG. 2D

CB    100    CF

101

EP 2 487 930 B1

# FIG. 3A

103

DIAPHRAGM
COMPLIANCE

C3

BACK CONTENT
COMPLIANCE

C2

C1

FRONT CONTENT
COMPLIANCE

# FIG. 3B

102

AMPLIFIER

100

LOAD IMPEDANCE VIEWED
FROM AMPLIFIER

CHANGE IN WEARING AND
NON-WEARING STATES

FIG. 4

# FIG. 5A

HEADPHONE WEARING STATE DETERMINATION UNIT 9

V0 →
V1 →
31 DIVISION UNIT (V0/V1) → Vdiv → 32 AVERAGING UNIT (LPF) → Vdiv_av → 33 DETERMINATION UNIT → SG1

# FIG. 5B

F101 OBTAIN Vdiv_av

F102 Vdiv_av > Vdiv_th?

NO

YES

F103 DETERMINE NON-WEARING STATE

F104 DETERMINE WEARING STATE

# FIG. 6

REPRODUCTION VOLUME
ACCUMULATION PROCESSING

CALCULATE REPRODUCTION VOLUME
VALUE THIS TIME FROM SIGNAL LEVEL,
GAIN OF GAIN ADJUSTMENT UNIT,
GAIN OF DAC/POWER AMPLIFIER — S10

ACCUMULATIVE VALUE ← ACCUMULATIVE
VALUE + REPRODUCTION VOLUME VALUE — S11

NO — ACCUMULATIVE VALUE ≥
REGULATORY VALUE? — S12

YES

GAIN REGULATION — S13

# FIG. 7A

(MUSIC SIGNAL REPRODUCTION)

S100
IS WEARING FLAG ON? → NO

YES

S101
HAS ON/OFF OF REPRODUCTION VOLUME ACCUMULATIVE LOGIC BEEN CHECKED? → OFF

ON

S104
STOP REPRODUCTION VOLUME ACCUMULATIVE LOGIC

S102
CONTINUE REPRODUCTION VOLUME ACCUMULATIVE LOGIC

S103
START/RESTART REPRODUCTION VOLUME ACCUMULATIVE LOGIC

S105
TIMER

# FIG. 7B

INTERRUPTION PROCESSING START

S201
HAS HEADPHONE DEVICE BEEN WORN? → NO

YES

S202
TURN ON WEARING FLAG

S203
TURN OFF WEARING FLAG

RET

EP 2 487 930 B1

## FIG. 8

9

FFT AMPLITUDE VALUE CALCULATION 34

SPECIFIC FREQUENCY V0f EXTRACTION 36

FFT AMPLITUDE VALUE CALCULATION 35

SPECIFIC FREQUENCY V1f EXTRACTION 37

DIVISION UNIT (V0f/V1f) 38

AVERAGING UNIT (LPF) 32

DETERMINATION UNIT 33

V0

V1

Vdivf

Vdivf_av

SG1

EP 2 487 930 B1

# FIG. 9

EP 2 487 930 B1

# FIG. 10

EP 2 487 930 B1

# FIG. 11

EP 2 487 930 B1

FIG. 12

AT THE TIME OF WEARING STATE : $R_{L\_on}$

AT THE TIME OF NON-WEARING STATE : $R_{L\_off}$

( $R_{L\_off} < R_{L\_on}$ )

20

21

Tp

TJ

C1

V0 V1

R1

15

3 DAC/POWER AMPLIFIER

2 GAIN

5 EQ

4 DECODER

6

7 CONTROL COMPUTATION UNIT

8

10 ADC (2ch)

Gout

V1

9 HEADPHONE WEARING STATE DETERMINATION UNIT (DSP)

SG1

13 OPERATION UNIT

14 DISPLAY UNIT

1

## FIG. 13

EP 2 487 930 B1

# FIG. 14

AT THE TIME OF WEARING STATE : $R_{L\_on}$

AT THE TIME OF NON-WEARING STATE : $R_{L\_off}$

($R_{L\_off} < R_{L\_on}$)

20

21

Tp

TJ

C1

V1

V0

R1

11

+

−

Vdiff

10

ADC (2ch)

Vdiff

Gout

15

3

DAC/POWER AMPLIFIER

2

GAIN

5

EQ

7

CONTROL COMPUTATION UNIT

8

9

HEADPHONE WEARING STATE DETERMINATION UNIT (DSP)

SG1

1

12

SYNTHESIZER

4

DECODER

6

Sweep SIGNAL
TSP SIGNAL
PINK NOISE
WHITE NOISE
M-SERIES SIGNAL

OPERATION UNIT

13

DISPLAY UNIT

14

34

## FIG. 15

EP 2 487 930 B1

# FIG. 16

CALIBRATION PROCESSING

```
         │◄──────────────────────────────┐
         ▼                               │
┌─────────────────────┐ S301             │
│      DISPLAY         │                  │
│ NON-WEARING MESSAGE  │                  │
└─────────────────────┘                  │
         │                               │
         ▼      S302                      │
      ╱────────────╲    NO               │
     ╱   START?    ╲────────────┐        │
      ╲────────────╱            │        │
         │ YES     S303          │        │
         ▼                       │        │
┌─────────────────────────────┐ │        │
│•START OUTPUT OF MEASUREMENT  │ │        │
│ SIGNAL                       │ │        │
│•START DISPLAY DURING         │ │        │
│ MEASUREMENT                  │ │        │
└─────────────────────────────┘ │        │
         │      S304              │        │
         ▼                        │        │
┌─────────────────────────────┐ │        │
│MEASURE OUTPUT FREQUENCY      │ │        │
│PROPERTY Vref AT THE TIME OF  │ │        │
│NON-WEARING STATE             │ │        │
└─────────────────────────────┘ │        │
         │◄──────────────┐      │        │
         ▼      S305       │     │        │
      ╱────────────╲      │     │        │
     ╱    HAS       ╲  NO │     │        │
    ╱ MEASUREMENT    ╲────┘     │        │
     ╲ BEEN          ╱          │        │
      ╲ COMPLETED?  ╱           │        │
       ╲──────────╱             │        │
         │ YES     S306          │        │
         ▼                       │        │
┌─────────────────────────────┐ │        │
│     STOP OUTPUT OF          │ │        │
│   MEASUREMENT SIGNAL        │ │        │
└─────────────────────────────┘ │        │
         │◄──────────────┐      │        │
         ▼      S307       │     │        │
┌─────────────────────────┐│    │        │
│ DISPLAY WEARING MESSAGE  ││    │        │
└─────────────────────────┘│    │        │
         │                 │    │        │
         ▼      S308        │    │        │
      ╱────────────╲   NO  │    │        │
     ╱   START?    ╲───────┘    │        │
      ╲────────────╱            │        │
         │ YES     S309          │        │
         ▼                       │        │
┌─────────────────────────────┐ │        │
│•START OUTPUT OF MEASUREMENT  │ │        │
│ SIGNAL                       │ │        │
│•START DISPLAY DURING         │ │        │
│ MEASUREMENT                  │ │        │
└─────────────────────────────┘ │        │
         │                       │        │
         └───────────────────────┘        │
```

```
         ┌──────────────────────────────┐
         ▼                               │
┌─────────────────────────────┐ S310     │
│MEASURE OUTPUT FREQUENCY      │          │
│PROPERTY Vear AT THE TIME OF  │          │
│WEARING STATE                 │          │
└─────────────────────────────┘          │
         │◄──────────────────┐           │
         ▼      S311           │          │
      ╱────────────╲          │          │
     ╱    HAS       ╲   NO    │          │
    ╱ MEASUREMENT    ╲────────┘          │
     ╲ BEEN          ╱                    │
      ╲ COMPLETED?  ╱                     │
       ╲──────────╱                       │
         │ YES     S312                    │
         ▼                                 │
┌─────────────────────────────┐           │
│     STOP OUTPUT OF          │           │
│   MEASUREMENT SIGNAL        │           │
└─────────────────────────────┘           │
         │      S313                        │
         ▼                                  │
┌─────────────────────────────┐            │
│   CALCULATE DIFFERENCE      │            │
│   BETWEEN Vear AND Vref     │            │
└─────────────────────────────┘            │
         │      S314                        │
         ▼                                  │
┌─────────────────────────────┐            │
│ CALCULATE PEAK FREQUENCY    │            │
│ AND GAIN OF DIFFERENCE      │            │
└─────────────────────────────┘            │
         │      S315                        │
         ▼                                  │
┌─────────────────────────────┐            │
│        SET ADJUSTMENT       │            │
└─────────────────────────────┘            │
         │      S316                        │
         ▼                                  │
┌─────────────────────────────┐            │
│ DISPLAY THAT MEASUREMENT    │            │
│ HAS BEEN COMPLETED          │            │
└─────────────────────────────┘            │
         │                                  │
         ▼                                  │
    ╭──────────╮                            │
    │ COMPLETE │                            │
    ╰──────────╯                            │
```

FIG. 17A

FIG. 17B

FIG. 17C

FIG. 17D

FIG. 17E

CALIBRATION
1/5
REMOVE EARPHONE
AND PRESS [START]
BUTTON

START

14

CALIBRATION
2/5

BEING MEASURED

14

CALIBRATION
3/5
WEAR EARPHONE
AND PRESS [START]
BUTTON

START

14

CALIBRATION
4/5

BEING MEASURED

14

CALIBRATION
5/5

MEASUREMENT
COMPLETED

14

EP 2 487 930 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3123199 A
- JP 64001400 A
- JP 2009159441 A
- US 20080025525 A
- WO 2008093954 A
- EP 1453349 A
- WO 2008000304 A